# EUROPEAN PATENT APPLICATION

(11) **EP 4 561 318 A1**
(43) Date of publication of application: **28.05.2025**
(21) Application number: 24214619.9
(22) Date of filing: 21.11.2024
(51) Int. Cl.: H10K 59/122, H10K 59/80

(54) **DISPLAY PANEL AND METHOD FOR MANUFACTURING THE SAME**

(30) Priority: 24.11.2023 KR 20230165700
(71) Applicant: Samsung Display Co., Ltd., Yongin-si, Gyeonggi-do 17113 (KR)
(72) Inventor: YANG, HEE JUN, 17113 Yongin-si (KR); SUNG, WOO YONG, 17113 Yongin-si (KR); LEE, JEONGSEOK, 17113 Yongin-si (KR)
(74) Representative: Taor, Simon Edward William

(57) **Abstract**

A display panel includes a base layer, a pixel-defining film on the base layer and having a light-emitting opening, a partition wall on the pixel-defining film and having a partition wall opening overlapping the light-emitting opening, a light-emitting element including an anode, an intermediate layer, and a cathode in contact with the partition wall and in the partition wall opening, and an inorganic encapsulation pattern including a first inorganic encapsulation pattern and a second inorganic encapsulation pattern sequentially arranged on the cathode. The first inorganic encapsulation pattern includes a plurality of inorganic patterns repeatedly stacked.

## Description

### CROSS-REFERENCE TO RELATED APPLICATION

The present application claims priority to and the benefit of Korean Patent Application No. 10-2023-0165700, filed on November 24, 2023.

### BACKGROUND

### 1. Field

Embodiments of the present disclosure herein relate to a display panel and a method for manufacturing the display panel, and for example, to a display panel with improved display quality.

### 2. Description of the Related Art

A display device, such as a television, a monitor, a smartphone, and a tablet computer which provide images to a user, includes a display panel which displays images. Various display panels such as liquid crystal display panels, organic light emitting display panels, electrowetting display panels, and/or electrophoretic display panels are being developed.

An organic light emitting display panel may include an anode, a cathode, and light-emitting patterns (e.g., therebetween). The light-emitting patterns may be separated from each other in one or more suitable light-emitting regions, and the cathode may provide a common voltage in each of the light-emitting regions.

The above information disclosed in this Background section is only for enhancement of understanding of the background of the disclosure and therefore it may contain information that does not constitute prior art.

### SUMMARY

Aspects of one or more embodiments of the present disclosure are directed toward a display panel which has improved display quality and on which a light-emitting element is formed without using a metal mask, and a method for manufacturing the display panel.

Additional aspects will be set forth in part in the description which follows and, in part, will be apparent from the description, or may be learned by practice of the presented embodiments of the disclosure.

One or more embodiments of the present disclosure provides a display panel including: a base layer; a pixel-defining film on the base layer and having a light-emitting opening; a partition wall on the pixel-defining film and having a partition wall opening overlapping the light-emitting opening; a light-emitting element including an anode, an intermediate layer, and a cathode (the cathode being) in contact with the partition wall and (the cathode being) in the partition wall opening; and an inorganic encapsulation pattern including a first inorganic encapsulation pattern and a second inorganic encapsulation pattern which are sequentially arranged on the cathode, wherein the first inorganic encapsulation pattern includes a plurality of inorganic patterns repeatedly stacked.

In one or more embodiments, the plurality of inorganic patterns may each include silicon nitride (SiNₓ) and/or silicon oxynitride (SiON).

In one or more embodiments, the plurality of inorganic patterns may each include a first sub-pattern and a second sub-pattern, and the first sub-pattern and the second sub-pattern may be sequentially and repeatedly stacked.

In one or more embodiments, the second sub-pattern may be more nitrogen (N)-rich than the first sub-pattern.

In one or more embodiments, the first sub-pattern may be more silicon (Si)-rich than the second sub-pattern.

In one or more embodiments, a thickness of the first sub-pattern may be smaller than a thickness of the second sub-pattern.

In one or more embodiments, the plurality of inorganic patterns may include five or more inorganic patterns.

In one or more embodiments, the partition wall may include a first partition wall layer on the pixel-defining film, and a second partition wall layer on the first partition wall layer, and the first partition wall layer may have an undercut shape with respect to the second partition wall layer.

In one or more embodiments of the present disclosure, a display panel includes: a base layer; a pixel-defining film on the base layer and having a light-emitting opening; a partition wall on the pixel-defining film and having a partition wall opening overlapping the light-emitting opening; a light-emitting element including an anode, an intermediate layer, and a cathode in contact with the partition wall and in the partition wall opening; and a first inorganic encapsulation pattern including a first inorganic pattern and a second inorganic pattern which are sequentially arranged on the cathode. The first inorganic pattern includes a (1-1)-th sub-pattern on the cathode and a (2-1)-th sub-pattern on the (1-1)-th sub-pattern, and the second inorganic pattern includes a (1-2)-th sub-pattern on the (2-1)-th sub-pattern and a (2-2)-th sub-pattern on the (1-2)-th sub-pattern.

In one or more embodiments, the first inorganic pattern and the second inorganic pattern may each include silicon nitride (SiNₓ) and/or silicon oxynitride (SiON).

In one or more embodiments, the first inorganic encapsulation pattern may include a first sub-pattern and a second sub-pattern, the first sub-pattern may include the (1-1)-th sub-pattern and the (1-2)-th sub-pattern, and the second sub-pattern may include the (2-1)-th sub-pattern and the (2-2)-th sub-pattern.

In one or more embodiments, the second sub-pattern may be more nitrogen (N)-rich than the first sub-pattern.

In one or more embodiments, the first sub-pattern may be more silicon (Si)-rich than the second sub-pattern.

In one or more embodiments, a thickness of the first sub-pattern may be smaller than a thickness of the second sub-pattern.

In one or more embodiments, the display panel may further include a second inorganic encapsulation pattern arranged on the (2-2)-th sub-pattern.

In one or more embodiments of the present disclosure, a method for manufacturing a display panel includes: providing a preliminary display panel including a base layer, a pixel-defining film on the base layer, a first preliminary partition wall layer on the pixel-defining film, and a second preliminary partition wall layer on the first preliminary partition wall layer; forming a first partition wall layer and a second partition wall layer having a partition wall opening by etching the first preliminary partition wall layer and the second preliminary partition wall layer; forming a light-emitting pattern and a cathode inside the partition wall opening; and forming an inorganic encapsulation pattern on the cathode. The forming of the inorganic encapsulation pattern includes depositing a first inorganic encapsulation layer on the cathode, depositing a second inorganic encapsulation layer on the first inorganic encapsulation layer, and forming a first inorganic encapsulation pattern and a second inorganic encapsulation pattern by etching the first inorganic encapsulation layer and the second inorganic encapsulation layer.

In one or more embodiments, the depositing of the first inorganic encapsulation layer on the cathode may include: depositing a (1-1)-th sub-layer on the cathode; and depositing a (2-1)-th sub-layer on the (1-1)-th sub-layer, wherein a first inorganic layer includes the (1-1)-th sub-layer and the (2-1)-th sub-layer, and the (1-1)-th sub-layer is silicon (Si)-rich and the (2-1)-th sub-layer is nitrogen (N)-rich.

In one or more embodiments, the depositing of the first inorganic encapsulation layer on the cathode may further include: depositing a (1-2)-th sub-layer on the first inorganic layer; and depositing a (2-2)-th sub-layer on the (1-2)-th sub-layer; wherein a second inorganic layer includes the (1-2)-th sub-layer and the (2-2)-th sub-layer, and the (1-2)-th sub-layer is silicon (Si)-rich and the (2-2)-th sub-layer is nitrogen (N)-rich.

In one or more embodiments, the depositing of the (1-1)-th sub-layer on the cathode may include: introducing a silicon-containing gas and an argon gas; and introducing a nitrogen-containing gas and the argon gas.

In one or more embodiments, the depositing of the (2-1)-th sub-layer on the (1-1)-th sub-layer may include: introducing a silicon-containing gas, a nitrogen-containing gas, and an argon gas; and introducing the nitrogen-containing gas and the argon gas.

According to an aspect, there is provided a display panel as set out in claim 1. Additional features are set out in claims 2 to 8. According to an aspect, there is provided a method as set out in claim 9. Additional features are set out in claims 10 to 13.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1A is a perspective view of a display device according to one or more embodiments of the present disclosure;
FIG. 1B is an exploded perspective view of a display device according to one or more embodiments of the present disclosure;
FIG. 2 is a cross-sectional view of a display module according to one or more embodiments of the present disclosure;
FIG. 3 is a plan view of a display panel according to one or more embodiments of the present disclosure;
FIG. 4 is an enlarged plan view of a part of a display region of a display panel according to one or more embodiments of the present disclosure;
FIG. 5 is a cross-sectional view of a display panel taken along the line I-I' of FIG. 3, according to one or more embodiments of the present disclosure;
FIG. 6 is an enlarged view of region AA' of FIG. 5, according to one or more embodiments of the present disclosure; and
FIGS. 7A-7M are cross-sectional or schematic views which illustrate some steps (e.g., acts or tasks) of a method for manufacturing a display panel according to one or more embodiments of the present disclosure.

### DETAILED DESCRIPTION

The present disclosure may be modified in many alternate forms, and thus specific embodiments will be illustrated in the drawings and described in more detail. It should be understood, however, that this is not intended to limit the present disclosure to the particular forms disclosed, but rather, is intended to cover all modifications, equivalents, and alternatives falling within the scope of the present disclosure.

Hereinafter, example embodiments will be described in more detail with reference to the accompanying drawings. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described.

In this specification, it will be understood that when an element, such as an area, layer, film, region or portion, is referred to as being "on," "connected to," or "coupled to" another element, it may be directly on, connected to, or coupled to another element, or one or more intervening elements may be present. In addition, it will also be understood that when an element is referred to as being "between" two elements, it can be the only element between the two elements, or one or more intervening elements may also be present.

Unless otherwise noted, like reference numerals or symbols refer to like elements throughout the attached drawings and the written description, and, thus, duplicative descriptions thereof may not be provided. Also, in the drawings, the thicknesses, ratios, sizes, and dimensions of the elements may be exaggerated for effective description of the technical contents.

As used herein, the term "and/or" includes any and all combinations of one or more of the associated listed items.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

As used herein, the singular forms "a," "an" and "the" are intended to include the plural forms as well, unless the context clearly indicates otherwise.

Spatially relative terms, such as "on," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the drawings. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (*e.g*., rotated 90 degrees or at other orientations) and the spatially relative descriptors used herein should be interpreted accordingly.

It will be further understood that the terms "comprises," "comprising," "includes," "including," "have," "having," "contain," and "containing," when used in this specification, specify the presence of the stated features, integers, steps, operations, elements, and/or components, but do not preclude the presence or addition of one or more other features, integers, steps, operations, elements, components, and/or groups thereof.

As used herein, the terms "use," "using," and "used" may be considered synonymous with the terms "utilize," "utilizing," and "utilized," respectively.

Unless otherwise apparent from the disclosure, expressions such as "at least one of," "a plurality of," "one of," and other prepositional phrases, when preceding a list of elements, should be understood as including the disjunctive if written as a conjunctive list and vice versa. For example, the expressions "at least one of a, b, or c," "at least one of a, b, and/or c," "one selected from the group consisting of a, b, and c," "at least one selected from among a, b, and c," "at least one from among a, b, and c," "one from among a, b, and c", "at least one of a to c" indicates only a, only b, only c, both a and b, both a and c, both b and c, all of a, b, and c, or variations thereof.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Hereinafter, embodiments of the present disclosure will be described with reference to the accompanying drawings.

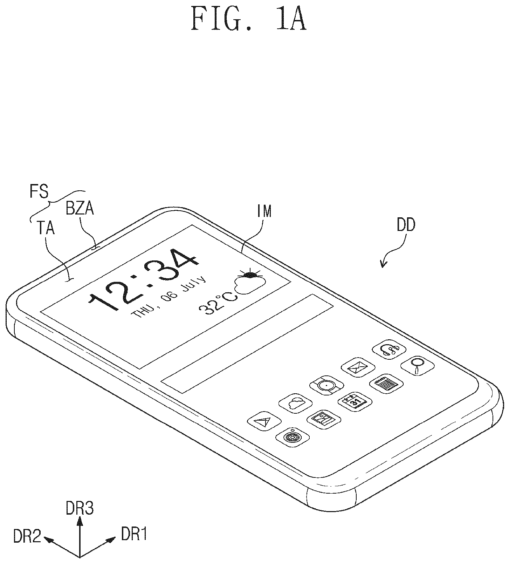

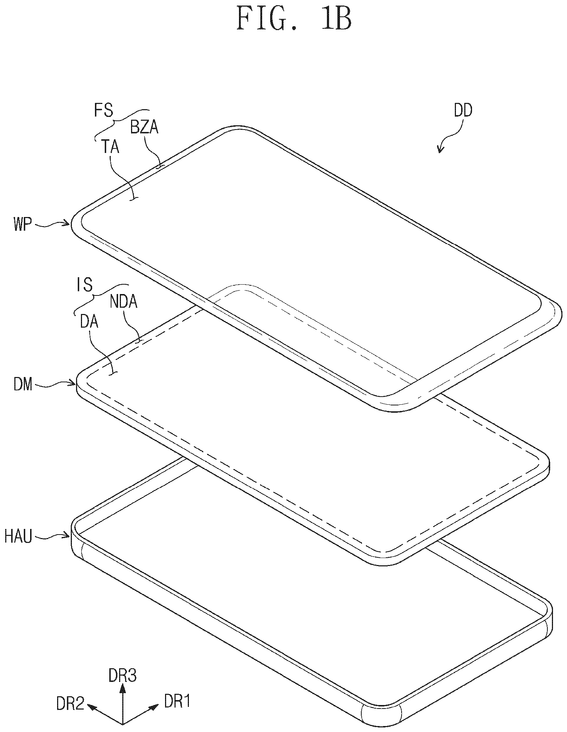

FIG. 1A is a perspective view of a display device DD according to one or more embodiments of the present disclosure, and FIG. 1B is an exploded perspective view of the display device DD according to one or more embodiments of the present disclosure.

In one or more embodiments, the display device DD may be a large-sized electronic device such as a television, a monitor, or an outdoor billboard. In one or more embodiments, the display device DD may be a medium- or small-sized device such as a personal computer, a laptop computer, a personal digital terminal, a car navigation unit, a game console, a smartphone, a tablet computer, or a camera. However, these are presented as examples, and the display device DD may also be employed as other display devices without departing from the present disclosure. In FIGS. 1A and 1B, the display device DD is illustrated as a smartphone as an example.

Referring to FIGS. 1A and 1B, the display device DD may display an image IM in a third direction DR3, on a display surface FS parallel to each of a first direction DR1 and a second direction DR2 (*e.g*., display the image in a plan view of the display device DD). The image IM may include not only a dynamic image but also a static image. In FIG. 1A, a clock display and application icons are illustrated as the images IM as an example. The display surface FS, on which the image IM is displayed, may correspond to a front surface of the display device DD.

In one or more embodiments, a front surface (or upper surface) and a rear surface (or lower surface) of each member are defined based on a direction in which the image IM is displayed. The front surface and the rear surface may be opposed to each other in a third direction DR3, and a normal (*e.g*., perpendicular) direction of each of the front surface and the rear surface may be parallel to the third direction DR3. In one or more embodiments, the directions indicated by the first to third directions DR1 to DR3 may be relative, and may thus be changed to other directions. In this specification, the wording "when viewed on a plane or "in a plan view" may refer to a case when viewed in the third direction DR3.

The display device DD may include a window WP, a display module DM, and a housing HAU. The window WP and the housing HAU may be coupled to each other to constitute the exterior of the display device DD.

The window WP may include an optically transparent insulating material. For example, the window WP may include glass or plastic. The front surface of the window WP may define the display surface FS of the display device DD. The display surface FS may include a transmission region TA and a bezel region BZA. The transmission region TA may be an optically transparent region. For example, the transmission region TA may be a region having a visible light transmittance of about 90% or more.

The bezel region BZA may be a region having a relatively lower light transmittance than the transmission region TA. The bezel region BZA may define the shape of the transmission region TA. The bezel region BZA may be adjacent to the transmission region TA and may be around (e.g., may surround) the transmission region TA. However, this is an example, and the bezel region BZA of the window WP may not be provided. The window WP may include at least one functional layer among (selected from among) an anti-fingerprint layer, a hard coating layer, and an anti-reflection layer, but embodiments of the present disclosure are not limited thereto.

The display module DM may be arranged below the window WP. The display module DM may be a component substantially generating the image IM. The image IM generated in the display module DM may be displayed on the display surface IS of the display module DM and be viewed by a user from the outside through the transmission region TA.

The display module DM may include a display region DA and a non-display region NDA. The display region DA may be activated in response to an electrical signal. The non-display region NDA may be adjacent to the display region DA. The non-display region NDA may be around (*e.g*., surround) the display region DA. The non-display region NDA may be a region covered by the bezel region BZA and may be invisible from the outside.

The housing HAU may be coupled to the window WP and may provide a set or predetermined inner space. The display module DM may be accommodated in the inner space.

The housing HAU may include a material having relatively high rigidity. For example, the housing HAU may include glass, plastic, or metal or include a plurality of frames and/or plates composed of combinations thereof. The housing HAU may stably protect components of the display device DD that are accommodated in the inner space against an external impact.

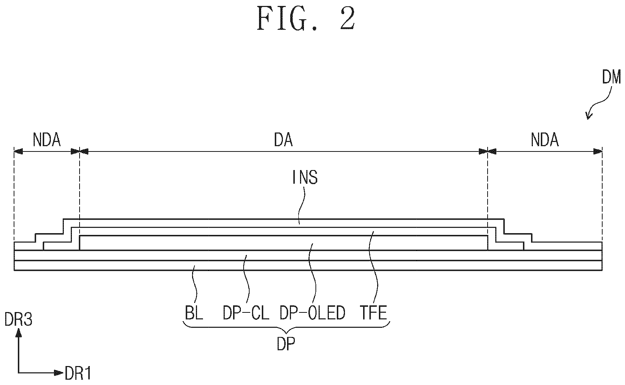

FIG. 2 is a cross-sectional view of a display module DM according to one or more embodiments of the present disclosure.

Referring to FIG. 2, the display module DM may include a display panel DP and an input sensor INS. In one or more embodiments, the display device DD (see, e.g., FIG. 1A) may further include a protection member arranged on a lower surface of the display panel DP, and/or an anti-reflection member and/or a window member arranged on an upper surface of the input sensor INS.

The display panel DP may be a light-emitting display panel. However, this is presented as an example, and embodiments of the present disclosure are not limited thereto. For example, the display panel DP may be an organic light-emitting display panel or an inorganic light-emitting display panel. A light-emitting layer in the organic light-emitting display panel may include an organic light-emitting material. A light-emitting layer in the inorganic light-emitting display panel may include quantum dots, quantum rods, or a micro LED. Hereinafter, the display panel DP is described as an organic light-emitting display panel.

The display panel DP may include a base layer BL, a circuit element layer DP-CL arranged on the base layer BL, a display element layer DP-OLED, and a thin-film encapsulation layer TFE. The input sensor INS may be directly arranged on the thin-film encapsulation layer TFE. In this specification, the wording, "an A component is directly arranged on a B component" means that an adhesive layer is not arranged between the A component and the B component (*e.g*., there is no other layer between the A component and the B component).

The base layer BL may include at least one plastic film. The base layer BL may include, a flexible substrate, a plastic substrate, a glass substrate, a metal substrate, an organic/inorganic composite material substrate, and/or the like. The display region DA and the non-display region NDA described in FIG. 1B may be similarly defined in the base layer BL (*e.g*., the base layer BL may be continuous throughout both the display region DA and the non-display region NDA).

The circuit element layer DP-CL may include at least one insulating layer or a circuit element. The insulating layer includes at least one inorganic layer and at least one organic layer. The circuit element includes signal lines, a pixel driving circuit, and/or the like.

The display element layer DP-OLED may include a partition wall and a light-emitting element. The light-emitting element may include an anode, an intermediate layer, and a cathode.

The thin-film encapsulation layer TFE may include a plurality of thin films. Some thin films may be arranged to improve optical efficiency, and other thin films may be arranged to protect organic light-emitting diodes.

The input sensor INS may acquire coordinate information about an external input. The input sensor INS may have a multi-layered structure. The input sensor INS may have a single- or multi-layered structure. Additionally, the input sensor INS may include a single- or multi-layered conductive layer. The input sensor INS may detect an external input in a capacitive manner. However, this is presented as an example, and embodiments of the present disclosure are not limited thereto. For example, in one or more embodiments, the input sensor INS may detect an external input in an electromagnetically inductive manner or in a pressure-sensitive manner. In one or more embodiments of the present disclosure, the input sensor INS may not be provided.

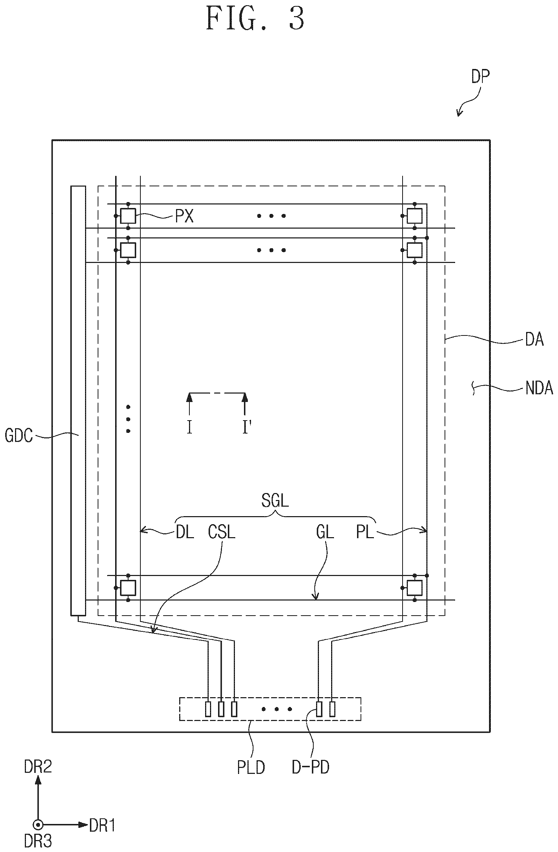

FIG. 3 is a plan view of a display panel DP according to one or more embodiments of the present disclosure.

Referring to FIG. 3, a display region DA and a non-display region NDA around the display region DA may be defined in the display panel DP. The display panel DP may include pixels PX and signal lines SGL electrically connected to the pixels PX. The display panel DP may include a driving circuit GDC and a pad part PLD. The display region DA and the non-display region NDA may be distinguished according to whether the pixels PX are present. The pixels PX are arranged in the display region DA. The driving circuit GDC and the pad part PLD may be arranged in the non-display region NDA.

The pixels PX may be arranged in the first direction DR1 and the second direction DR2. The pixels PX may include a plurality of pixel rows which extend in the first direction DR1 and are aligned in the second direction DR2, and a plurality of pixel columns which extend in the second direction DR2 and are aligned in the first direction DR1.

The signal lines SGL may include gate lines GL, data lines DL, a power line PL, and a control signal line CSL. The gate lines GL may be respectively connected to corresponding pixels PX among the pixels PX, and the data lines DL may be respectively connected to corresponding pixels PX among the pixels PX. The power line PL may be electrically connected to the pixels PX. The control signal line CSL may be connected to a driving circuit GDC and provide control signals to the driving circuit GDC.

The driving circuit GDC may include a gate driving circuit. The gate driving circuit may generate gate signals and sequentially output the generated gate signals to the gate lines GL. The gate driving circuit may further output another control signal to a pixel driving circuit.

The pad part PLD may be a part to which a flexible circuit board is connected. The pad part PLD may include pixel pads D-PD, which may be pads for connecting the flexible circuit board to the display panel DP. The pixel pads D-PD may be respectively connected to corresponding signal lines SGL among the signal lines SGL. The pixel pads D-PD may be connected to the corresponding pixels PX via the signal lines SGL. In one or more embodiments, one pixel pad D-PD among the pixel pads D-PD may be connected to the driving circuit GDC.

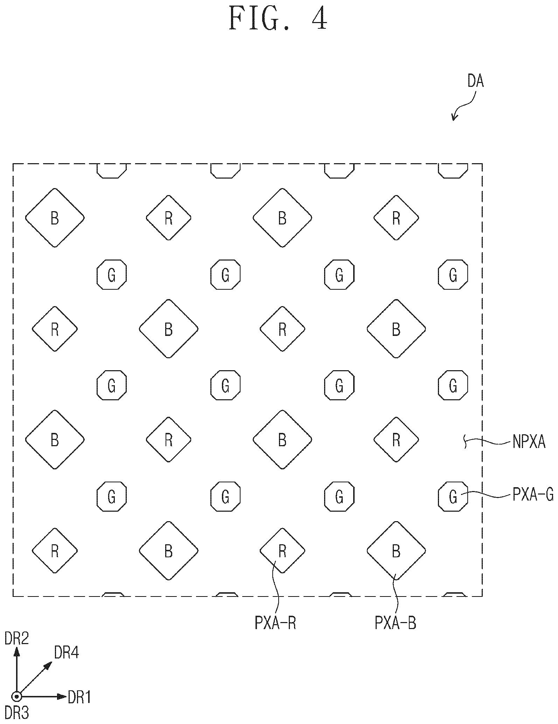

In one or more embodiments, the pad part PLD may further include input pads. The input pads may be pads for connecting the flexible circuit board to the input sensor INS (*see*, *e.g*., FIG. 2). However, embodiments of the present disclosure are not limited thereto, and the input pads may be arranged in the input sensor INS (*see*, *e.g*., FIG. 2) and be connected to a circuit board which is separate from the pixel pads D-PD. In one or more embodiments, the input sensor INS (*see*, e*.g.,* FIG. 2) may not be provided, and may not further include the input pads. FIG. 4 is an enlarged plan view of a part of the display region DA (*see*, *e.g*., FIG 2) of the display panel DP (*see*, *e.g*., FIG. 2) according to one or more embodiments of the present disclosure. FIG. 4 is a plan view illustrating a display module DM as viewed from above the display surface IS (*see*, *e.g.*, FIG. 1B) of the display module DM (*see*, *e.g*., FIG. 1B), and illustrates an arrangement of light-emitting regions PXA-R, PXA-G, and PXA-B.

Referring to FIG. 4, the display region DA may include first to third light-emitting regions PXA-R, PXA-G, and PXA-B and a peripheral region NPXA around (*e.g*., surrounding) the first to third light-emitting regions PXA-R, PXA-G, and PXA-B. The first to third light-emitting regions PXA-R, PXA-G, and PXA-B may respectively correspond to regions in which light provided from light-emitting elements is emitted. The first to third light-emitting regions PXA-R, PXA-G, and PXA-B may be distinguished according to colors of light emitted toward the outside of the display module DM (*see, e.g.,* FIG. 2).

The first to third light-emitting regions PXA-R, PXA-G, and PXA-B may respectively provide first-color light to third-color light having different colors. For example, the first-color light may be red light, the second-color light may be green light, and the third-color light may be blue light. However, examples of the first- to third-color light are not necessarily limited to the examples described above.

The first to third light-emitting regions PXA-R, PXA-G, and PXA-B may be respectively defined as regions in each of which an upper surface of an anode is exposed by a light-emitting opening to be described in more detail later. The peripheral region NPXA may define boundaries between the first to third light-emitting regions PXA-R, PXA-G, and PXA-B and prevent or reduce color-mixing between the first to third light-emitting regions PXA-R, PXA-G, and PXA-B.

Each of the first to third light-emitting regions PXA-R, PXA-G, and PXA-B may be provided in a plurality, and may be repeatedly arranged in a set or predetermined arrangement form within the display region DA. For example, the first light-emitting regions PXA-R and the third light-emitting regions PXA-B may be alternately arranged along the first direction DR1 to form a 'first group'. The second light-emitting regions PXA-G may be arranged along the first direction DR1 to form a 'second group'. The 'first group' and the 'second group' may be each provided in a plurality, and the 'first groups' and the 'second groups' may be alternately arranged along the second direction DR2.

One second light-emitting region PXA-G may be arranged to be spaced and/or apart (*e.g*., spaced apart or separated) from one first light-emitting region PXA-R or one third light-emitting region PXA-B in a fourth direction DR4. The fourth direction DR4 may be defined as a direction between the first direction DR1 and the second direction DR2.

In one or more embodiments, FIG. 4 illustrates the arrangement form of the first to third light-emitting regions PXA-R, PXA-G, and PXA-B, and the light-emitting regions may be arranged in one or more suitable forms without being limited thereto. In one or more embodiments, as illustrated in FIG. 4, the first to third light-emitting regions PXA-R, PXA-G, and PXA-B may be arranged in a Pentile^{®} form (PENTILE^{®} is a duly registered trademark of Samsung Display Co.). In one or more embodiments, the first to third light-emitting regions PXA-R, PXA-G, and PXA-B may be arranged in a stripe form or a Diamond Pixel^{®} form (DIAMOND PIXEL^{®} is a duly registered trademark of Samsung Display Co.).

The first to third light-emitting regions PXA-R, PXA-G, and PXA-B may have one or more suitable shapes on a plane (*e.g*., in a plan view). For example, the first to third light-emitting regions PXA-R, PXA-G, and PXA-B may each have a shape of polygon, circle, oval, and/or the like. FIG. 4 illustrates that on a plane (*e.g.,* in a plan view), the first light-emitting regions PXA-R and the third light-emitting regions PXA-B may each have a quadrilateral shape (or a rhombic shape) and the second light-emitting regions PXA-G may each have an octagonal shape.

On a plane (*e.g.,* in a plan view), the first to third light-emitting regions PXA-R, PXA-G, and PXA-B may have substantially identical or similar shapes or may have at least partially different shapes. FIG. 4 illustrates that on a plane (*e.g.,* in a plan view), the first light-emitting regions PXA-R and the third light-emitting regions PXA-B may have substantially identical shapes, and the second light-emitting regions PXA-G may have a different shape from the respective shapes of the first light-emitting regions PXA-R and the third light-emitting regions PXA-B.

At least some selected from among the first to third light-emitting regions PXA-R, PXA-G, and PXA-B may have different areas on a plane (*e.g*., in a plan view). In one or more embodiments, the area of each of the first light-emitting regions PXA-R emitting red light may be greater than the area of each of the second light-emitting regions PXA-G emitting green light and may be smaller than the area of each of the third light-emitting regions PXA-B emitting blue light. However, the area size relationship among (selected from among) the first to third light-emitting regions PXA-R, PXA-G, and PXA-B according to the color of emitted light is not limited thereto, and may vary according to a design of the display module DM (*see, e.g.,* FIG. 2). Also, embodiments of the present disclosure are not limited thereto, and the first to third light-emitting regions PXA-R, PXA-G, and PXA-B may each have the same area on a plane (*e.g.,* in a plan view).

In one or more embodiments, the shape, area, and arrangement of the first to third light-emitting regions PXA-R, PXA-G, and PXA-B of the display module DM (*see, e.g.,* FIG. 2) according to one or more embodiments of the present disclosure may be variously designed according to the color of emitted light, or the size or configuration of the display module DM (*see, e.g.,* FIG. 2), and are not limited to the one or more embodiments illustrated in FIG. 4.

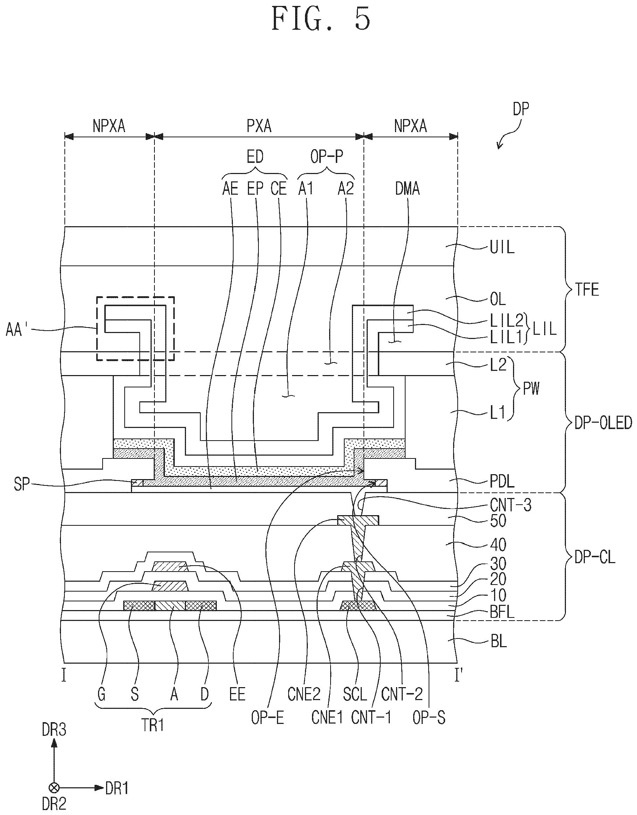

FIG. 5 is a cross-sectional view of a display panel taken along the line I-I' of FIG. 3, according to one or more embodiments of the present disclosure. FIG. 5 will be described with reference to FIG. 2, and the description of the same reference numerals or symbols may not be provided.

FIG. 5 is an enlarged view illustrating one light-emitting region PXA within the display region DA (*see*, *e.g*.*,* FIG. 4), and the light-emitting region PXA of FIG. 5 may correspond to any one among the first to third light-emitting regions PXA-R, PXA-G, and PXA-B of FIG. 4. Referring to FIG. 5, a display panel DP may include a base layer BL, a circuit element layer DP-CL, a display element layer DP-OLED, and a thin-film encapsulation layer TFE.

The display panel DP may include a plurality of insulating layers, a semiconductor pattern, a conductive pattern, a signal line, and/or the like. An insulating layer, a semiconductor layer, and a conductive layer are formed through coating, deposition, and/or the like. Thereafter, the insulating layer, the semiconductor layer, and the conductive layer may be selectively patterned by performing a photolithography and/or an etching. In this manner, the semiconductor pattern, the conductive pattern, the signal line, and/or the like included in the circuit element layer DP-CL and the display element layer DP-OLED are formed.

The circuit element layer DP-CL may be arranged on the base layer BL. The circuit element layer DP-CL may include a buffer layer BFL, a transistor TR1, a signal transmission region SCL, first to fifth insulating layers 10, 20, 30, 40, and 50, an electrode EE, and a plurality of connection electrodes CNE1 and CNE2.

The buffer layer BFL may be arranged on the base layer BL. The buffer layer BFL may improve a bonding force between the base layer BL and the semiconductor pattern. The buffer layer BFL may include a silicon oxide layer and a silicon nitride layer. The silicon oxide layer and the silicon nitride layer may be alternately stacked.

The semiconductor pattern may be arranged on the buffer layer BFL. The semiconductor pattern may include polysilicon. However, the semiconductor pattern is not limited thereto, and may include amorphous silicon, or a metal oxide. In FIG. 5, a portion of the semiconductor pattern is merely illustrated as an example, and a semiconductor pattern is further arranged in (e.g., in each of) the plurality of light-emitting regions PXA-R, PXA-G, and PXA-B (*see, e.g*.*,* FIG. 4). The semiconductor pattern may be arranged across the plurality of light-emitting regions PXA-R, PXA-G, and PXA-B in accordance with the specific rule. The electrical properties of the semiconductor pattern may vary depending on whether it is doped or not. The semiconductor pattern may include a first region having a higher doping concentration, and a second region having a lower doping concentration. The first region may be doped with an N-type or kind dopant or a P-type or kind dopant. A P-type or kind transistor may include the first region doped with the P-type or kind dopant.

The first region has higher conductivity than the second region and substantially serves as an electrode or a signal line. The second region may substantially correspond to an active region (or channel) of a transistor. For example, a portion of the semiconductor pattern may be an active region of a transistor, another portion may be a source or drain of a transistor, and still another portion may be a conductive region.

A source S, an active A, and a drain D of the transistor TR1 may be formed from the semiconductor pattern. FIG. 5 illustrates a portion of the signal transmission region SCL formed from the semiconductor pattern. In one or more embodiments, the signal transmission region SCL may be connected, on a plane (*e.g.,* in a plan view), to the drain D of the transistor TR1.

The first to fifth insulating layers 10, 20, 30, 40, and 50 may be arranged on the buffer layer BFL. The first to fifth insulating layers 10, 20, 30, 40, and 50 may be inorganic layers and/or organic layers.

The first insulating layer 10 may be arranged on the buffer layer BFL. The first insulating layer 10 may cover the source S, the active A, the drain D, and the signal transmission region SCL of the transistor TR1 arranged on the buffer layer BFL. A gate G of the transistor TR1 may be arranged on the first insulating layer 10. The second insulating layer 20 may be arranged on the first insulating layer 10 and may cover the gate G. The electrode EE may be arranged on the second insulating layer 20. The third insulating layer 30 may be arranged on the second insulating layer 20 and cover the electrode EE.

The first connection electrode CNE1 may be arranged on the third insulating layer 30. The first connection electrode CNE1 may be connected to the signal transmission region SCL via a contact hole CNT-1 passing through the first to third insulating layers 10, 20, and 30. The fourth insulating layer 40 may be arranged on the third insulating layer 30 and cover the first connection electrode CNE1. The fourth insulating layer 40 may be an organic layer.

The conductive pattern CNE2 may be arranged on the fourth insulating layer 40. The second connection electrode CNE2 may be connected to the first connection electrode CNE1 via a contact hole CNT-2 passing through the fourth insulating layer 40. The fifth insulating layer 50 may be arranged on the fourth insulating layer 40 and cover the second connection electrode CNE2. The fifth insulating layer 50 may be an organic layer.

The display element layer DP-OLED may be arranged on the circuit element layer DP-CL. The display element layer DP-OLED may include a light-emitting element ED, a sacrificial pattern SP, a pixel-defining film PDL, and a partition wall PW.

The light-emitting element ED may include the anode AE (or first electrode), a light-emitting pattern EP, and the cathode CE (or second electrode).

The anode AE may be arranged on the fifth insulating layer 50 of the circuit element layer DP-CL. The anode AE may be a transmissive electrode, a transflective electrode, or a reflective electrode. The anode AE may be connected to the second connection electrode CNE2 via a contact hole CNT-3 which is defined by passing through the fifth insulating layer 50. Accordingly, the anode AE may be electrically connected to the signal transmission region SCL via the first and second connection electrodes CNE1 and CNE2 and may be electrically connected to a corresponding circuit element. The anode AE may have a single layer or multi-layered structure. The anode AE may include a plurality of layers containing ITO and Ag. For example, the anode AE may include an ITO-containing layer (hereinafter, lower ITO layer), an Ag-containing layer (hereinafter, Ag layer) arranged on the lower ITO layer, and an ITO-containing layer (hereinafter, upper ITO layer) arranged on the Ag layer.

The sacrificial pattern SP may be arranged between the anode AE and the pixel-defining film PDL. In the sacrificial pattern SP, a sacrificial opening OP-S which exposes a portion of an upper surface of the anode AE may be defined (or, the sacrificial pattern SP may have the sacrificial opening OP-S). The sacrificial opening OP-S may overlap a light-emitting opening OP-E to be described in more detail later.

The pixel-defining film PDL may be arranged on the fifth insulating layer 50 of the circuit element layer DP-CL. In the pixel-defining film PDL, the light-emitting opening OP-E may be defined (or, the pixel-defining film PDL may have the light-emitting opening OP-E). The light-emitting opening OP-E may correspond to the anode AE, and the pixel-defining film PDL may expose at least a portion of the anode AE via the light-emitting opening OP-E.

In one or more embodiments, the light-emitting opening OP-E may correspond to the sacrificial opening OP-S of the sacrificial pattern SP. According to one or more embodiments, because an upper surface of the anode AE may be spaced and/or apart (*e.g*., spaced apart or separated) from the pixel-defining film PDL with the sacrificial pattern SP therebetween in a cross sectional view, it is possible to protect the anode AE from damage during a process of forming the light-emitting opening OP-E.

On a plane (*e.g*., in a plan view), the area of the light-emitting opening OP-E may be smaller than the area of the sacrificial opening OP-S. For example, an inner side surface of the pixel-defining film PDL which defines the light-emitting opening OP-E may extend closer to the center of the anode AE than an inner side surface of the sacrificial pattern SP which defines the sacrificial opening OP-S. However, embodiments of the present disclosure are not limited thereto, and the inner side surface of the sacrificial pattern SP which defines the sacrificial opening OP-S may also be substantially aligned with the inner side surface of the pixel-defining film PDL which defines the light-emitting opening OP-E. In such embodiments, the light-emitting region PXA may be considered as a region of the anode AE, exposed by a corresponding sacrificial opening OP-S.

The pixel-defining film PDL may include an inorganic insulating material. For example, the pixel-defining film PDL may include SiNₓ (or silicon nitride). The pixel-defining film PDL may be arranged between the anode AE and the partition wall PW, and thus block the anode AE and the partition wall PW from being electrically connected to each other.

The light-emitting pattern EP may be arranged on the anode AE. The light-emitting pattern EP may further include a light-emitting layer including a light-emitting material. The light-emitting pattern EP may further include a hole injection layer (HIL) and/or a hole transport layer (HTL) arranged between the anode AE and the light-emitting layer, or may further include an electron transport layer (ETL) and/or an electron injection layer (EIL) arranged on the light-emitting layer. The light-emitting pattern EP may be referred to as an 'organic layer' or an 'intermediate layer'.

The light-emitting pattern EP may be patterned by a tip portion defined in the partition wall PW. The light-emitting pattern EP may be arranged inside the sacrificial opening OP-S, the light-emitting opening OP-E, and the partition wall opening OP-P. The light-emitting pattern EP may cover a portion of an upper surface of the pixel-defining film PDL exposed by the partition wall opening OP-P.

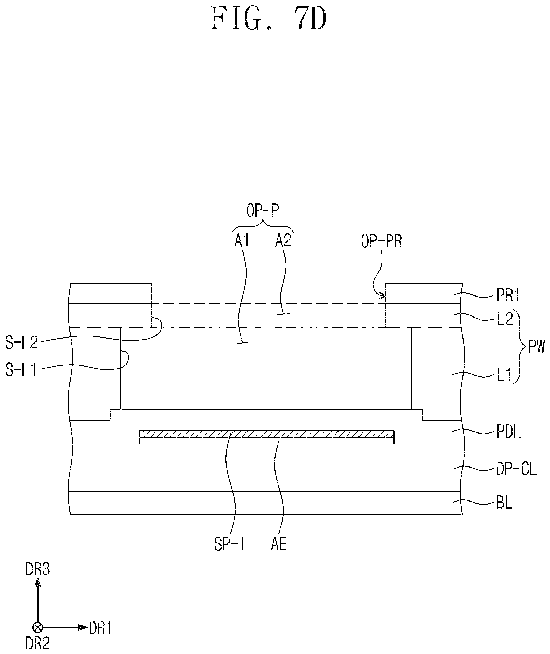

The cathode CE may be arranged on the light-emitting pattern EP. The cathode CE may be patterned by the tip portion defined in the partition wall PW (where the tip portion may be a portion of the partition wall PW that extends closer to the center of the anode AE relative to other portions of the partition wall PW). At least a portion of the cathode CE may be arranged in the partition wall opening OP-P. The cathode CE may be in contact with a first inner side surface S-L1 (*see, e.g.,* FIG. 7D) of a first partition wall layer L1. The cathode CE may have conductivity (e.g., be an electron conductor). The cathode CE may be formed from one or more suitable materials such as a metal, a transparent conductive oxide (TCO), or a conductive polymer material as long as the materials have conductivity. For example, the cathode CE may include silver (Ag), magnesium (Mg), lead (Pb), copper (Cu), or one or more compounds thereof.

In one or more embodiments of the present disclosure, the display element layer DP-OLED may further include a capping pattern. The capping pattern may be arranged inside the partition wall opening OP-P and arranged on the cathode CE. The capping pattern may be patterned by the tip portion formed in the partition wall PW.

The partition wall PW may be arranged on the pixel-defining film PDL. In the partition wall PW, the partition wall opening OP-P may be defined (or, the partition wall PW may have the partition wall opening OP-P). The partition wall opening OP-P may correspond to the light-emitting opening OP-E, and may expose at least a portion of the anode AE.

The partition wall PW may have an undercut shape in a cross-sectional view. The partition wall PW may include a plurality of layers sequentially stacked, and at least one layer among the plurality of layers may be further recessed away from the center of the anode AE than other layers. Accordingly, the partition wall PW may include the tip portion (*e.g.,* a portion of the partition wall PW that extends closer to the center of the anode AE relative to other recessed portions of the partition wall PW).

The partition wall PW may include the first partition wall layer L1 and a second partition wall layer L2. The first partition wall layer L1 may be arranged on the pixel-defining film PDL, and the second partition wall layer L2 may be arranged on the first partition wall layer L1. As illustrated in FIG. 5, the thickness of the first partition wall layer L1 may be greater than the thickness of the second partition wall layer L2, but embodiments of the present disclosure are not limited thereto.

The first partition wall layer L1 may be further recessed than the second partition wall layer L2 with respect to the light-emitting region PXA. The first partition wall layer L1 may be formed to be undercut with respect to the second partition wall layer L2. A portion of the second partition wall layer L2 projected from the first partition wall layer L1 toward the light-emitting region PXA may be defined as the tip portion of the partition wall PW.

The partition wall opening OP-P defined in the partition wall PW may include a first region A1 and a second region A2. The first partition wall layer L1 may include a first inner side surface defining the first region A1 of the partition wall opening OP-P, and the second partition wall layer L2 may include a second inner side surface defining the second region A2. In a cross-sectional view, the second inner side surface of the second partition wall layer L2 may extend closer to the center of the anode AE than the first inner side surface of the first partition wall layer L1. The first inner side surface may be further recessed than the second inner side surface, in a direction extending farther away from the center of the anode AE. Accordingly, the second partition wall layer L2 that projects toward the light-emitting region PXA may include the tip portion.

The width of the first region A1 may be different from the width of the second region A2. The width of the first region A1 may be greater than the width of the second region A2. In one or more embodiments, the second region A2 of the partition wall opening OP-P may be a region defining the tip portion.

The first partition wall layer L1 and the second partition wall layer L2 may each include a conductive material. For example, the conductive material may include a metal, a transparent conductive oxide (TCO), and/or a (*e.g*., any suitable) combination thereof. For example, the metal may include gold (Au), silver (Ag), aluminum (Al), magnesium (Mg), lithium (Li), molybdenum (Mo), titanium (Ti), copper (Cu), and/or an alloy. The transparent conductive oxide may include indium tin oxide (ITO), indium zinc oxide (IZO), zinc oxide, indium oxide, indium gallium oxide, indium gallium zinc oxide (IGZO), and/or aluminum zinc oxide.

FIG. 5 illustrates that the first inner side surface and the second inner side surface each are normal (*e.g*., perpendicular) to an upper surface of the pixel-defining film PDL, but embodiments of the present disclosure are not limited thereto. For example, the partition wall PW may have a tapered shape or an inversed tapered shape.

The partition wall PW may receive a second driving voltage. Accordingly, the cathode CE may be electrically connected to the partition wall PW to receive the second driving voltage.

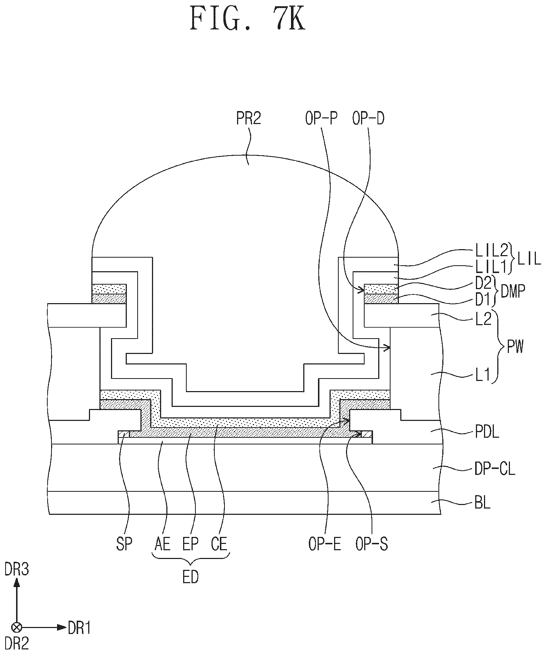

A dummy region DMA may be formed on the partition wall PW. For example, the dummy region DMA may be formed, in a cross-sectional view, between the partition wall PW and an inorganic encapsulation pattern LIL (or lower inorganic encapsulation pattern LIL). The dummy region DMA may be defined as a region in which dummy patterns DMP (*see, e.g.,* FIG. 7K) are formed and removed during the later-described manufacturing process of the display panel.

The thin-film encapsulation layer TFE may be arranged on the display element layer DP-OLED. The thin-film encapsulation layer TFE may include a lower inorganic encapsulation pattern LIL, an organic encapsulation film OL, and an upper inorganic encapsulation film UIL. The lower inorganic encapsulation pattern LIL may be referred to as an inorganic encapsulation pattern LIL.

The lower inorganic encapsulation pattern LIL may correspond to the light-emitting opening OP-E. The lower inorganic encapsulation pattern LIL may be arranged on the cathode CE. For example, a portion of the lower inorganic encapsulation pattern LIL may be formed inside the partition wall opening OP-P, and another portion of the lower inorganic encapsulation pattern LIL may be formed on the partition wall PW. The lower inorganic encapsulation pattern LIL may include a first lower inorganic encapsulation pattern LIL1 (or first inorganic encapsulation pattern) and a second lower inorganic encapsulation pattern LIL2 (or second inorganic encapsulation pattern). The first lower inorganic encapsulation pattern LIL1 and the second lower inorganic encapsulation pattern LIL2 may be sequentially arranged on the cathode CE. The first lower inorganic encapsulation pattern LIL1 may be referred to as a first inorganic encapsulation pattern LIL1, and the second lower inorganic encapsulation pattern LIL2 may be referred to as a second inorganic encapsulation pattern LIL2.

The organic encapsulation film OL may cover the lower inorganic encapsulation pattern LIL and provide a flat upper surface. The dummy region DMA may be filled with a portion of the organic encapsulation film OL. The upper inorganic encapsulation film UIL may be arranged on the organic encapsulation film OL.

The lower inorganic encapsulation pattern LIL and the upper inorganic encapsulation film UIL may protect the display element layer DP-OLED against moisture and/or oxygen, and the organic encapsulation film OL may protect the display element layer DP-OLED against foreign substances such as dust particles.

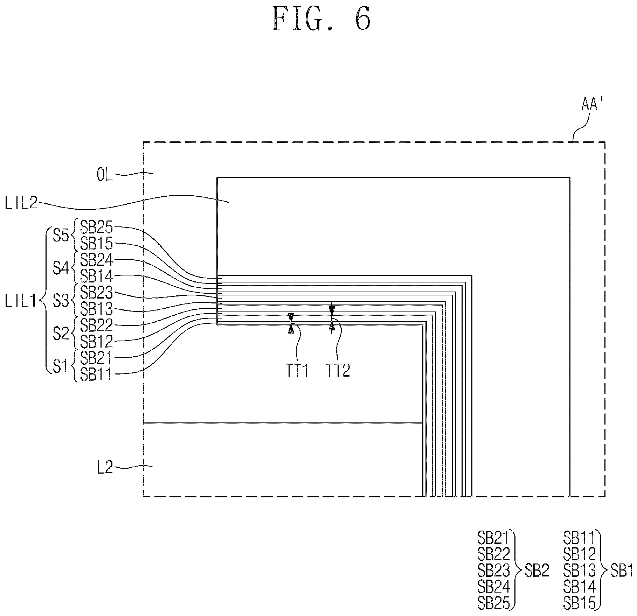

FIG. 6 is an enlarged view illustrating region AA' of FIG. 5, according to one or more embodiments of the present disclosure.

Referring to FIGS. 5 and 6, the first lower inorganic encapsulation pattern LIL1 may include a plurality of inorganic patterns S1, S2, S3, S4, and S5, which are repeatedly stacked. The plurality of inorganic patterns S1, S2, S3, S4, and S5 may each include silicon nitride (SiNₓ) and/or silicon oxynitride (SiON (e.g., SiOₓN_{y})). The plurality of inorganic patterns S1, S2, S3, S4, and S5 may each include a first sub-pattern SB1 and a second sub-pattern SB2. The first sub-pattern SB1 may include first sub-patterns SB11, SB12, SB13, SB14, and SB15, and the second sub-pattern SB2 may include second sub-patterns SB21, SB22, SB23, SB24, and SB25. The first sub-patterns SB11, SB12, SB13, SB14, and SB15 and the second sub-patterns SB21, SB22, SB23, SB24, and SB25 may be sequentially and repeatedly stacked.

For example, the plurality of inorganic patterns S1, S2, S3, S4, and S5 may include a first inorganic pattern S1, a second inorganic pattern S2, a third inorganic pattern S3, a fourth inorganic pattern S4, and a fifth inorganic pattern S5. The first inorganic pattern S1 may include a (1-1)-th sub-pattern SB11 which is the first sub-pattern SB1 and a (2-1)-th sub-pattern SB21 which is the second sub-pattern SB2. The second inorganic pattern S2 may include a (1-2)-th sub-pattern SB12 which is the first sub-pattern SB1, and a (2-2)-th sub-pattern SB22 which is the second sub-pattern SB2. The third inorganic pattern S3 may include a (1-3)-th sub-pattern SB13 which is the first sub-pattern SB1 and a (2-3)-th sub-pattern SB23 which is the second sub-pattern SB2. The fourth inorganic pattern S4 may include a (1-4)-th sub-pattern SB14 which is the first sub-pattern SB1, and a (2-4)-th sub-pattern SB24 which is the second sub-pattern SB2. The fifth inorganic pattern S5 may include a (1-5)-th sub-pattern SB15 which is the first sub-pattern SB1 and a (2-5)-th sub-pattern SB25 which is the second sub-pattern SB2.

The (1-1)-th sub-pattern SB11, the (2-1)-th sub-pattern SB21, the (1-2)-th sub-pattern SB12, the (2-2)-th sub-pattern SB22, the (1-3)-th sub-pattern SB13, the (2-3)-th sub-pattern SB23, the (1-4)-th sub-pattern SB14, the (2-4)-th sub-pattern SB24, the (1-5)-th sub-pattern SB15, and the (2-5)-th sub-pattern SB25 may be sequentially stacked on the cathode CE. In this case, one among the first sub-patterns SB11, SB12, SB13, SB14, and SB15, and one among the second sub-patterns SB21, SB22, SB23, SB24, and SB25 may be sequentially and alternately stacked.

The first sub-pattern SB1 and the second sub-pattern SB2 may each include silicon nitride (SiNₓ) and/or silicon oxynitride (SiON). The first sub-pattern SB1 may be more silicon (Si)-rich than the second sub-pattern SB2, and the second sub-pattern SB2 may be more nitrogen (N)-rich than the first sub-pattern SB1. For example, the first sub-pattern SB1 may be a silicon nitride (SiNₓ) and/or silicon oxynitride (SiON) layer which is silicon (Si)-rich, and the second sub-pattern SB2 may be a silicon nitride (SiNₓ) or silicon oxynitride (SiON) layer which is nitrogen (N)-rich. The thickness TT1 of the first sub-pattern SB1 may be smaller than the thickness TT2 of the second sub-pattern SB2. However, this is illustrated as an example, and the thickness TT1 of the first sub-pattern SB1 and the thickness TT2 of the second sub-pattern SB2 are not limited thereto. Also, as a non-limiting example, in Si₃N₄, silicon-rich refer to a condition in which a composition has a higher silicon-to-nitrogen ratio (Si/N) than the stoichiometric Si₃N₄ compound. In contrast, as a non-limiting example, in Si₃N₄, nitrogen-rich refer to a condition in which a lower Si/N ratio than the stoichiometric compound. In summary, silicon-rich Si₃N₄ has an excess of silicon, while nitrogen-rich Si₃N₄ has an excess of nitrogen.

FIG. 6 illustrates that the plurality of inorganic patterns S1, S2, S3, S4, and S5 include five inorganic patterns S1, S2, S3, S4, and S5, but embodiments of the present disclosure are not limited thereto. For example, the plurality of inorganic patterns may include two to four inorganic patterns, or include six or more inorganic patterns.

A second lower inorganic encapsulation pattern LIL2 may be arranged on a first lower inorganic encapsulation pattern LIL1. The thickness of the second lower inorganic encapsulation pattern LIL2 may be greater than the thickness of the first lower inorganic encapsulation pattern LIL1. However, embodiments of the present disclosure are not limited thereto, and the thickness of the second lower inorganic encapsulation pattern LIL2 may be the same as or smaller than the thickness of the first lower inorganic encapsulation pattern LIL1.

According to one or more embodiments of the present disclosure, the lower inorganic encapsulation pattern LIL may include the plurality of inorganic patterns S1, S2, S3, S4, and S5, and the plurality of inorganic patterns S1, S2, S3, S4, and S5 may each include silicon nitride (SiNₓ) and/or silicon oxynitride (SiON). The plurality of inorganic patterns S1, S2, S3, S4, and S5 including silicon nitride (SiNₓ) and/or silicon oxynitride (SiON) may cover the partition wall PW, thereby reducing or eliminating the phenomenon in which the lower inorganic encapsulation pattern LIL is oxidized due to foreign substances introduced from a side surface of the first partition wall layer L1, a lower surface of the second partition wall layer L2, and/or a side surface of the second partition wall layer L2. Therefore, pixel defects (dark spots, pixel shrinkage, and/or the like) of the display panel DP caused by foreign substances may be reduced or eliminated.

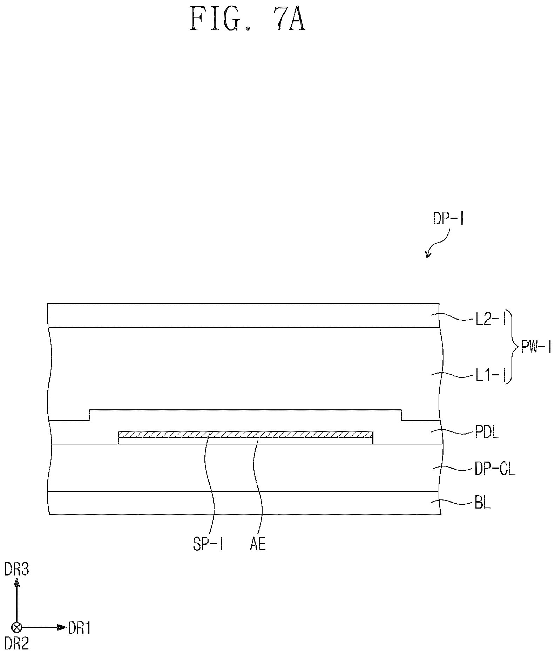

FIGS. 7A to 7M are cross-sectional or schematic views which illustrate some steps (e.g., acts or tasks) of a method for manufacturing a display panel according to one or more embodiments of the present disclosure. In the description of FIGS. 7A to 7M, the same/similar reference numerals or symbols are used for the description of the components same/similar to those described with reference to FIGS. 1 to 6, and a duplicated description thereof may not be provided.

The method for manufacturing the display panel according to one or more embodiments of the present disclosure may include the steps of: providing a preliminary display panel including a base layer, a pixel-defining film arranged on the base layer, a first preliminary partition wall layer arranged on the pixel-defining film, and a second preliminary partition wall layer arranged on the first preliminary partition wall layer; forming a first partition wall layer and a second partition wall layer having a partition wall opening by etching the first preliminary partition wall layer and the second preliminary partition wall layer; forming a light-emitting pattern and a cathode inside the partition wall opening; and forming an inorganic encapsulation pattern on the cathode. The step (*e.g*., act or task) of forming the inorganic encapsulation pattern may include depositing a first inorganic encapsulation layer on the cathode, depositing a second inorganic encapsulation layer on the first inorganic encapsulation layer, and forming a first inorganic encapsulation pattern and a second inorganic encapsulation pattern by etching the first inorganic encapsulation layer and the second inorganic encapsulation layer.

Hereinafter, with reference to FIGS. 7A to 7M, a method of forming one light-emitting element ED, a lower inorganic encapsulation pattern LIL covering the light-emitting element ED, an organic encapsulation film OL, and an upper inorganic encapsulation film UIL will be described. The display panel formed through the steps of FIGS. 7A to 7M may correspond to the display panel DP of FIG. 5, according to one or more embodiments of the present disclosure.

Referring to FIG. 7A, the method for manufacturing the display panel according to one or more embodiments may include providing a preliminary display panel DP-I. The preliminary display panel DP-I provided in one or more embodiments may include a base layer BL, a circuit element layer DP-CL, an anode AE, a sacrificial layer SP-I, a pixel-defining film PDL, a first preliminary partition wall layer L1-I, and a second preliminary partition wall layer L2-I.

The circuit element layer DP-CL may be formed through a suitable circuit element manufacturing process that involves forming an insulating layer, a semiconductor layer, and a conductive layer through coating, deposition, and/or the like, selectively patterning the insulating layer, the semiconductor layer, and the conductive layer by performing photolithography and/or etching processes, and then forming a semiconductor pattern, a conductive pattern, and a signal line.

The anode AE and the sacrificial layer SP-I may be formed through the same patterning process(es). The pixel-defining film PDL may be arranged on the base layer BL. The pixel-defining film PDL may cover both the anode AE and the sacrificial layer SP-I.

The first preliminary partition wall layer L1-I may be arranged on the pixel-defining film PDL. The first preliminary partition wall layer L1-I may be formed through a process of depositing a conductive material. The second preliminary partition wall layer L2-I may be arranged on the first preliminary partition wall layer L1-I. The second preliminary partition wall layer L2-I may also be formed through a process of depositing a conductive material. In one or more embodiments, the first preliminary partition wall layer L1-I and the second preliminary partition wall layer L2-I may each include a conductive material. For example, the conductive material may include a metal, a transparent conductive oxide (TCO), and/or a (*e.g*., any suitable) combination thereof. For example, the metal may include gold (Au), silver (Ag), aluminum (Al), magnesium (Mg), lithium (Li), molybdenum (Mo), titanium (Ti), copper (Cu), and/or an alloy. The transparent conductive oxide may include indium tin oxide (ITO), indium zinc oxide (IZO), zinc oxide, indium oxide, indium gallium oxide, indium gallium zinc oxide (IGZO), and/or aluminum zinc oxide. However, the materials of the first preliminary partition wall layer L1-I and the second preliminary partition wall layer L2-I are not limited thereto. The first preliminary partition wall layer L1-I and the second preliminary partition wall layer L2-I may form a preliminary partition wall PW-I.

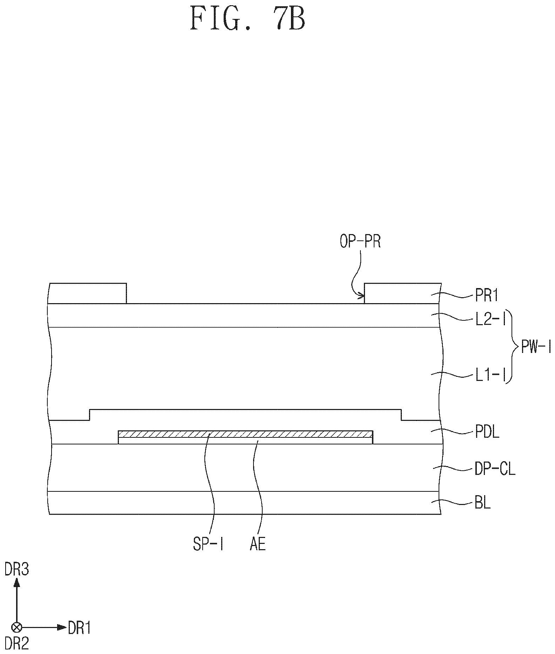

Thereafter, referring to FIG. 7B, the method for manufacturing the display panel according to one or more embodiments may include forming a first photoresist layer PR1 on the preliminary partition wall PW-I. The first photoresist layer PR1 may be formed by forming a preliminary photoresist layer on the preliminary partition wall PW-I and then, patterning the preliminary photoresist layer, using a photo mask. Through the patterning process, a first photo opening OP-PR overlapping the anode AE may be formed in the first photoresist layer PR1.

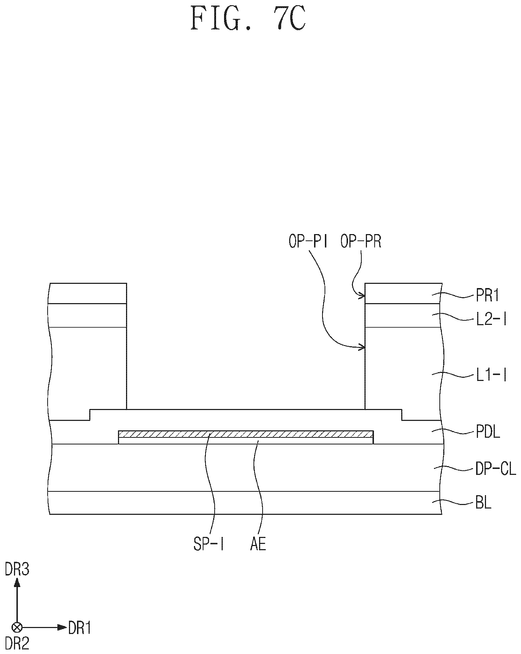

Thereafter, referring to FIGS. 7C and 7D, the method for manufacturing the display panel according to one or more embodiments may include forming a first partition wall layer L1 and a second partition wall layer L2 having a partition wall opening OP-P by etching the first preliminary partition wall layer L1-I and the second preliminary partition wall layer L2-I, so that a partition wall PW is formed from the preliminary partition wall PW-I (*see, e.g.,* FIG. 7B).

First, as illustrated in FIG. 7C, the step (*e.g*., act or task) of the primarily etching the first preliminary partition wall layer L1-I and the second preliminary partition wall layer L2-I may include forming a preliminary partition wall opening OP-PI in the preliminary partition wall PW-I by dry etching the first preliminary partition wall layer L1-I and the second preliminary partition wall layer L2-I, using the first photoresist layer PR1 as a mask.

In one or more embodiments, the primary dry-etching process may be performed under the etching condition in which an etching selectivity between (*e.g.,* the etch rate of) the first preliminary partition wall layer L1-I and the second preliminary partition wall layer L2-I is substantially the same. Accordingly, an inner side surface of the first preliminary partition wall layer L1-I and an inner side surface of the second preliminary partition wall layer L2-I, which define the preliminary partition wall opening OP-PI, may be substantially aligned.

Thereafter, as illustrated in FIG. 7D, the step (*e.g*., act or task) of secondarily etching the first preliminary partition wall layer L1-I may include forming the partition wall opening OP-P from the preliminary partition wall opening OP-PI (*see, e.g.,* FIG. 7C) by wet etching the first preliminary partition wall layer L1-I, using the first photoresist layer PR1 as a mask.

The partition wall opening OP-P may include a first region A1 and a second region A2 sequentially formed in a thickness direction (that is, third direction DR3). The first partition wall layer L1 may include a first inner side surface S-L1 which defines the first region A1 of the partition wall opening OP-P, and the second partition wall layer L2 may include a second inner side surface S-L2 which defines the second region A2.

In one or more embodiments, the secondary wet-etching process may be performed under the etching condition in which an etching selectivity between (*e.g.,* the etch rate of) the first preliminary partition wall layer L1-I and the second preliminary partition wall layer L2-I is great. Accordingly, the inner side surface of the partition wall PW which defines the partition wall opening OP-P may have an undercut shape in a cross-sectional view. For example, in an etching solution, the etch rate of the first partition wall layer L1 is greater than the etch rate of the second partition wall layer L2, and thus the first partition wall layer L1 may be mainly etched. Accordingly, the first inner side surface S-L1 of the first partition wall layer L1 may be formed to be further recessed than the second inner side surface S-L2 of the second partition wall layer L2. A portion, of the second partition wall layer L2, projected further than the first partition wall layer L1 may form a tip portion in the partition wall PW.

In one or more embodiments, the step (*e.g.,* act or task) of forming the partition wall opening OP-P of FIGS. 7C and 7D may include concurrently (*e.g*., simultaneously) forming partition wall openings OP-P corresponding to the first to third light-emitting regions PXA-R, PXA-G, and PXA-B (*see, e.g.,* FIG. 4). However, embodiments of the present disclosure are not limited thereto, and in one or more embodiments of the present disclosure, the step (*e.g*., act or task) of the forming the partition wall opening OP-P may include forming only the partition wall opening OP-P corresponding to the first light-emitting region PXA-R. For example, after the partition wall opening OP-P corresponding to the first light-emitting region PXA-R is formed, and then the first light-emitting element is formed through a subsequent process, the partition wall opening OP-P corresponding to the second light-emitting region PXA-G may be formed. Also, the second light-emitting element is formed through a subsequent process, and then the partition wall opening OP-P corresponding to the third light-emitting region PXA-B may be formed.

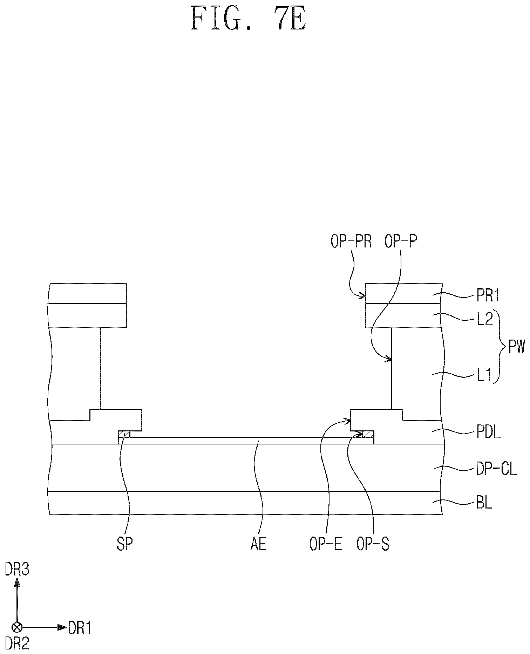

Thereafter, referring to FIG. 7E, the method for manufacturing the display panel according to one or more embodiments may include etching the pixel-defining film PDL, and etching the sacrificial layer SP-I (*see, e.g.,* FIG. 7D). The etching process of the pixel-defining film PDL may be performed through dry etching, and the pixel-defining film PDL may be etched using, as a mask, the first photoresist layer PR1 and the partition wall PW (for example, second partition wall layer L2). A light-emitting opening OP-E corresponding to the partition wall opening OP-P may be formed in the pixel-defining film PDL.

The etching process of the sacrificial layer SP-I may be performed through wet etching, and the sacrificial layer SP-I may be etched using, as a mask, the first photoresist layer PR1 and the partition wall PW (for example, second partition wall layer L2). A sacrificial opening OP-S overlapping the light-emitting opening OP-E may be formed in a sacrificial pattern SP formed by etching the sacrificial layer SP-I. Due to the sacrificial opening OP-S and the light-emitting opening OP-E, at least a portion of the anode AE may be exposed from the sacrificial pattern SP and the pixel-defining film PDL.

The etching process of the sacrificial pattern SP may be performed under the condition in which an etching selectivity (*e.g.,* etch rate) between the sacrificial pattern SP and the anode AE is great, and thus it is possible to prevent or reduce the likelihood that the anode AE is etched together with the sacrificial pattern SP. For example, the sacrificial pattern SP having an etch rate greater than that of the anode AE is arranged between the pixel-defining film PDL and the anode AE, and thus during the etching process, it is possible to prevent or reduce the likelihood that the anode AE is etched together with the sacrificial pattern SP and damaged.

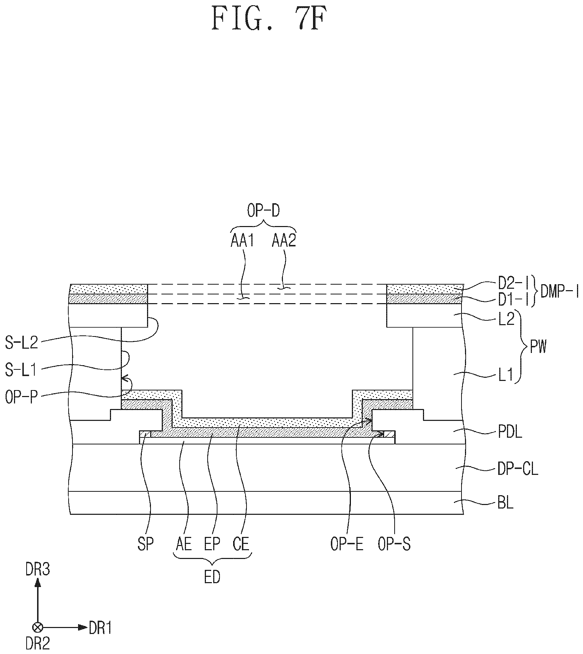

Thereafter, referring to FIG. 7F, the method for manufacturing the display panel according to one or more embodiments may include removing the first photoresist layer PR1 (*see, e.g.,* FIG. 7E), and then forming a light-emitting pattern EP and the cathode CE inside the partition wall opening OP-P.

The steps (e.g., acts or tasks) of forming the light-emitting pattern EP and the cathode CE may each be performed through a deposition process. In one or more embodiments, the step (*e.g.*, act or task) of forming the light-emitting pattern EP may include a thermal evaporation process, and the step (*e.g*., act or task) of forming the cathode CE may include a sputtering process.

The light-emitting pattern EP may be formed on the anode AE. In the step (*e.g*., act or task) of forming the light-emitting pattern EP, the light-emitting pattern EP may be separated from the tip portion formed in the partition wall PW and may be arranged inside the light-emitting opening OP-E and the partition wall opening OP-P.

In the step (*e.g*., act or task) of forming the light-emitting pattern EP, a first dummy layer D1-I spaced and/or apart (*e.g*., spaced apart or separated) from the light-emitting pattern EP may be formed together on the partition wall PW. The first dummy layer D1-I may include an organic material. For example, the first dummy layer D1-I may include the same material as that of the light-emitting pattern EP. The first dummy layer D1-I may be concurrently (*e.g*., simultaneously) formed with the light-emitting pattern EP through a single process, and may be formed to be separated from the light-emitting pattern EP due to an undercut shape of the partition wall PW.

The cathode CE may be formed on the light-emitting pattern EP. In the step (*e.g*., act or task) of forming the cathode CE, the cathode CE may be separated by the tip portion formed in the partition wall PW and may be arranged inside the partition wall opening OP-P. Because the cathode CE may be provided to have an incident angle higher than that of the light-emitting pattern EP, the cathode CE may be formed to be in contact with the first inner side surface S-L1 of the first partition wall layer L1. The anode AE, the light-emitting pattern EP, and the cathode CE may constitute the light-emitting element ED.

In the step (*e.g*., act or task) of forming the cathode CE, a second dummy layer D2-I spaced and/or apart (*e.g*., spaced apart or separated) from the cathode CE may be formed together on the partition wall PW. The second dummy layer D2-I may include a conductive material. For example, the second dummy layer D2-I may include the same material as that of the cathode CE. The second dummy layer D2-I may be concurrently (*e.g*., simultaneously) formed with the cathode CE through a single process, and be formed to be separated from the cathode CE due to an undercut shape of the partition wall PW.

The first dummy layer D1-I and the second dummy layer D2-I may be sequentially stacked on an upper surface of the partition wall PW along the third direction DR3. The first dummy layer D1-I and the second dummy layer D2-I form a dummy layer DMP-I, and a dummy opening OP-D may be formed in the dummy layer DMP-I. The dummy opening OP-D may include a first region AA1 and a second region AA2 sequentially formed in a thickness direction (*e.g*., third direction DR3). The first region AA1 of the dummy opening OP-D may be defined by an inner side surface of the first dummy layer D1-I, and the second region AA2 may be defined by an inner side surface of the second dummy layer D2-I.

In one or more embodiments of the present disclosure, the method for manufacturing the display panel may include forming a capping pattern. The step (*e.g*., act or task) of forming the capping pattern may include a thermal evaporation process. The capping pattern may be formed on the cathode CE. In the step (*e.g*., act or task) of forming the capping pattern, the capping pattern may be separated by the tip portion formed in the partition wall PW and may be arranged inside the partition wall opening OP-P.

In the step (*e.g*., act or task) of forming the capping pattern, a third dummy layer spaced and/or apart (*e.g*., spaced apart or separated) from the capping pattern may be formed together on the partition wall PW. The third dummy layer may include a conductive material. For example, the third dummy layer may include the same material as that of the capping pattern. The third dummy layer may be concurrently (*e.g.*, simultaneously) formed with the capping pattern through a single process, and be formed to be separated from the capping pattern due to an undercut shape of the partition wall PW. In such embodiments, the dummy layer DMP-I may include a first dummy layer D1-I, a second dummy layer D2-I, and a third dummy layer.

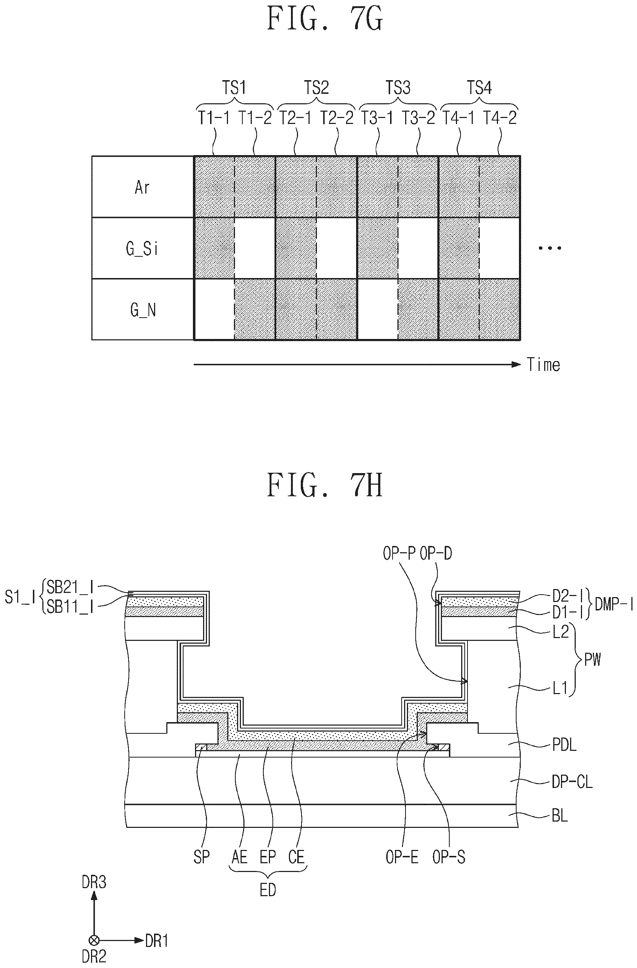

Thereafter, referring to FIGS. 7G to 7K, the method for manufacturing the display panel according to one or more embodiments may include forming the lower inorganic encapsulation pattern LIL on the cathode CE. The step (*e.g*., act or task) of forming the lower inorganic encapsulation pattern LIL may include depositing a first lower inorganic encapsulation layer LIL1_I (or first inorganic encapsulation layer) on the cathode CE, depositing a second lower inorganic encapsulation layer LIL2_I (or second inorganic encapsulation layer) on the first lower inorganic encapsulation layer LIL1_I, and forming a first lower inorganic encapsulation pattern LIL1 and a second lower inorganic encapsulation pattern LIL2 by etching the first lower inorganic encapsulation layer LIL1_I and the second lower inorganic encapsulation layer LIL2_I. The first lower inorganic encapsulation layer LIL1_I may be referred to as the first inorganic encapsulation layer LIL1_I, and the second lower inorganic encapsulation layer LIL2_I may be referred to as the second inorganic encapsulation layer LIL2_I.

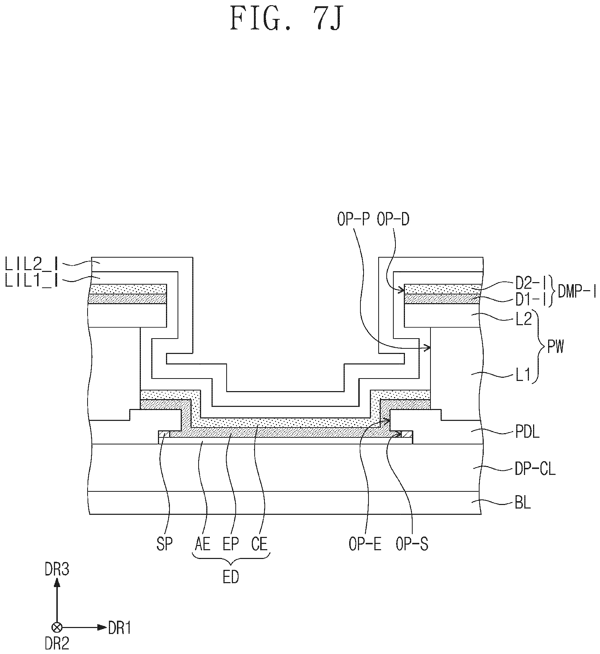

Hereinafter, the step (*e.g*., act or task) of depositing the first lower inorganic encapsulation layer LIL1_I will be described with reference to FIGS. 7G to 7I, the step (*e.g*., act or task) of depositing the second lower inorganic encapsulation layer LIL2_I will be described with reference to FIG. 7J, and the step (*e.g*., act or task) of forming the first and second lower inorganic encapsulation patterns LIL1 and LIL2 will be described with reference to FIG. 7K.

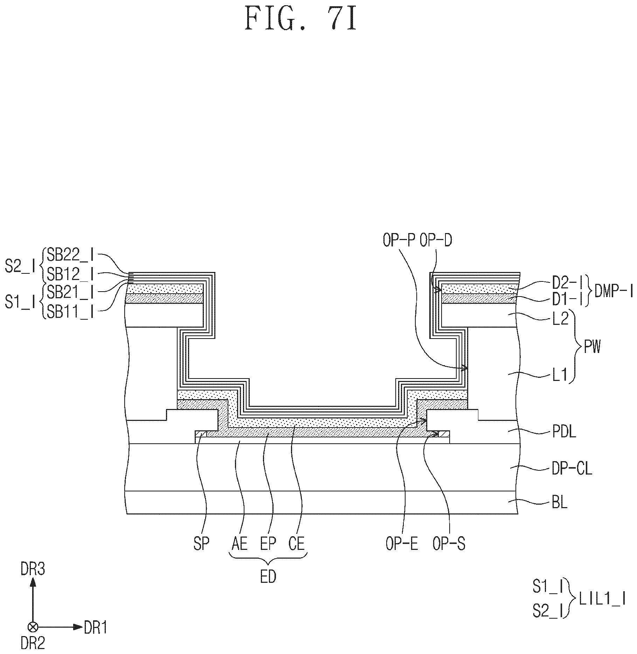

FIG. 7G is a schematic view illustrating gases (Ar, G_Si, and G_N) injected over time during the process of depositing the first lower inorganic encapsulation layer LIL1_I. The process of depositing the first lower inorganic encapsulation layer LIL1_I may be a process of forming a thin film on a substrate (for example, the preliminary display panel DP-I (*see, e.g.,* FIG. 7A) having the partition wall PW formed therein) by injecting reaction gases. FIG. 7G illustrates a first reaction stage TS1, a second reaction stage TS2, a third reaction stage TS3, and a fourth reaction stage TS4. The first reaction stage TS1 may correspond to a step of (*e.g*., act or task) depositing a (1-1)-th sub-layer SB11_I to be described in more detail later (*see, e.g.,* FIG. 7H), and the second reaction stage TS2 may correspond to a step (*e.g*., act or task) of depositing a (2-1)-th sub-layer SB21_I (see, *e..g,* FIG. 7H). The third reaction stage TS3 may correspond to a step (*e.g*., act or task) of depositing a (1-2)-th sub-layer SB12_I (see, *e.g.,* FIG. 7I), and the fourth reaction stage TS4 may correspond to a step (e.g., act or task) of depositing a (2-2)-th sub-layer SB22_I (*see, e.g.,* FIG. 7I).

The third reaction stage TS3 and the fourth reaction stage TS4 may be substantially the same as the respective first and second reaction stages TS1 and TS2. The third reaction stage TS3 may be substantially the same as the first reaction stage TS1, and the fourth reaction stage TS4 may be substantially the same as the second reaction stage TS2. For example, the process of depositing the first lower inorganic encapsulation layer LIL1_I may be a process in which the first reaction stage TS1 and the second reaction stage TS2 are repeatedly and alternatively performed.

First, referring to FIGS. 7G and 7H, the step (*e.g*., act or task) of depositing the first lower inorganic encapsulation layer LIL1_I on the cathode CE may include depositing the (1-1)-th sub-layer SB11_I on the cathode CE, depositing the (2-1)-th sub-layer SB21_I on the (1-1)-th sub-layer SB11_I, and thus forming a first inorganic layer S1_I including the (1-1)-th sub-layer SB11_I and the (2-1)-th sub-layer SB21_I.

The step (*e.g*., act or task) of depositing the (1-1)-th sub-layer SB11_I on the cathode CE may include introducing a silicon-containing gas (G_Si) and an argon gas (Ar), and then introducing the nitrogen-containing gas (N_Si) and the argon gas (Ar). For example, the silicon-containing gas (G_Si) may be silane (SiH₄), and the nitrogen-containing gas (N_Si) may be ammonia (NH₃).

For example, the first reaction stage TS1 may include an early stage T1-1 and a later stage T1-2. After the early stage T1-1, the later stage T1-2 may be performed. The early stage T1-1 of the first reaction stage TS1 may include introducing the silicon-containing gas (G_Si) and the argon gas (Ar). Due to the early stage T1-1, amorphous silicon may be formed on the cathode CE. The later stage T1-2 of the first reaction stage TS1 may include introducing the nitrogen-containing gas (N_Si) and the argon gas (Ar). Due to the later stage T1-2, nitridation of the amorphous silicon formed in the early stage (T1-1) may be carried out. As a result, the (1-1)-th sub-layer SB11_I may be formed on the cathode CE, and the (1-1)-th sub-layer SB11_I may be a silicon nitride (SiNₓ) and/or silicon oxynitride (SiON) layer which is silicon (Si)-rich.

The step (*e.g*., act or task) of depositing the (2-1)-th sub-layer SB21_I on the (1-1)-th sub-layer SB11_I may include introducing a silicon-containing gas (G_Si), a nitrogen-containing gas (N_Si), and an argon gas (Ar), and then introducing the nitrogen-containing gas (N_Si) and the argon gas (Ar). For example, the silicon-containing gas (G_Si) may be silane (SiH₄), and the nitrogen-containing gas (N_Si) may be ammonia (NH₃).

For example, the second reaction stage TS2 may include an early stage T2-1 and a later stage T2-2. After the early stage T2-1, the later stage T2-2 may be performed. The early stage T2-1 of the second reaction stage TS2 may include introducing the silicon-containing gas (G_Si), a nitrogen-containing gas (N_Si), and the argon gas (Ar). Due to the early stage T2-1, silicon nitride (SiNₓ) and/or silicon oxynitride (SiON) may be formed on the (1-1)-th sub-layer SB11_I. The later stage T2-2 of the second reaction stage TS2 may include introducing the nitrogen-containing gas (N_Si) and the argon gas (Ar). Due to the later stage T2-2, nitridation of the silicon nitride (SiNₓ) and/or silicon oxynitride (SiON) formed in the early stage (T2-1) may be carried out. As a result, the (2-1)-th sub-layer SB21_I may be formed on the (1-1)-th sub-layer SB11_I, and the (2-1)-th sub-layer SB21_I may be a silicon nitride (SiNₓ) and/or silicon oxynitride (SiON) layer, which is nitrogen (N)-rich.

The (1-1)-th sub-layer SB11_I and the (2-1)-th sub-layer SB21_I may form the first inorganic layer S1_I.

Referring to FIGS. 7G and 7I, the step (e.g., act or task) of depositing the first lower inorganic encapsulation layer LIL1_I on the cathode CE may further include depositing a (1-2)-th sub-layer SB12_I on the first inorganic layer S1_I, depositing a (2-2)-th sub-layer SB22_I on the (1-2)-th sub-layer SB12_I, and thus forming a second inorganic layer S2_I including the (1-2)-th sub-layer SB12_I and the (2-2)-th sub-layer SB22_I.

The step (*e.g*., act or task) of depositing the (1-2)-th sub-layer SB12_I on the first inorganic layer S1_I may include introducing a silicon-containing gas (G_Si) and an argon gas (Ar), and then introducing a nitrogen-containing gas (N_Si) and the argon gas (Ar). For example, the silicon-containing gas (G_Si) may be silane (SiH₄), and the nitrogen-containing gas (N_Si) may be ammonia (NH₃).

For example, the third reaction stage TS3 may include an early stage T3-1 and a later stage T3-2. After the early stage T3-1, the later stage T3-2 may be performed. The early stage T3-1 of the first reaction stage TS3 may include introducing a silicon-containing gas (G_Si) and an argon gas (Ar). Due to the early stage T3-1, amorphous silicon may be formed on the (2-1)-th sub-layer SB21_I. The later stage T3-2 of the third reaction stage TS3 may be include introducing a nitrogen-containing gas (N_Si) and the argon gas (Ar). Due to the later stage T3-2, nitridation of the amorphous silicon formed in the early stage (T3-1) may be carried out. As a result, the (1-2)-th sub-layer SB12_I may be formed on the first inorganic layer S1_I, and the (1-2)-th sub-layer SB12_I may be a silicon nitride (SiNₓ) and/or silicon oxynitride (SiON) layer, which is silicon (Si)-rich.

The step (*e.g*., act or task) of depositing the (2-2)-th sub-layer SB22_I on the (1-2)-th sub-layer SB12_I may include introducing a silicon-containing gas (G_Si), a nitrogen-containing gas (N_Si), and an argon gas (Ar), and then introducing the nitrogen-containing gas (N_Si) and the argon gas (Ar). For example, the silicon-containing gas (G_Si) may be silane (SiH₄), and the nitrogen-containing gas (N_Si) may be ammonia (NH₃).

For example, the fourth reaction stage TS4 may include an early stage T4-1 and a later stage T4-2. After the early stage T4-1, the later stage T4-2 may be performed. The early stage T4-1 of the fourth reaction stage TS4 may include introducing a silicon-containing gas (G_Si), a nitrogen-containing gas (N_Si), and an argon gas (Ar). Due to the early stage T4-1, silicon nitride (SiNₓ) and/or silicon oxynitride (SiON) may be formed on the (1-2)-th sub-layer SB12_I. The later stage T4-2 of the fourth reaction stage TS4 may include introducing a nitrogen-containing gas (N_Si) and the argon gas (Ar). Due to the later stage T4-2, nitridation of the silicon nitride (SiNₓ) and/or silicon oxynitride (SiON) formed in the early stage (T4-1) may be carried out. As a result, the (2-2)-th sub-layer SB22_I may be formed on the (1-2)-th sub-layer SB12_I, and the (2-2)-th sub-layer SB22_I may be a silicon nitride (SiNₓ) and/or silicon oxynitride (SiON) layer, which is nitrogen (N)-rich.

The (1-2)-th sub-layer SB12_I and the (2-2)-th sub-layer SB22_I may form the second inorganic layer S2_I.

The (1-1)-th sub-layer SB11_I of the first inorganic layer S1_I and the (1-2)-th sub-layer SB12_I of the second inorganic layer S2_I may be referred to as first sub-layers SB11_I and SB12_I, and the (2-1)-th sub-layer SB21_I of the first inorganic layer S1_I and the (2-2)-th sub-layer SB22_I of the second inorganic layer S2_I may be referred to as second sub-layers SB21_I and SB22_I. The first sub-layers SB11_I and SB12_I and the second sub-layers SB21_I and SB22_I may each include silicon nitride (SiNₓ) and/or silicon oxynitride (SiON). The first sub-layers SB11_I and SB12_I may be more silicon (Si)-rich than the second sub-layers SB21_I and SB22_I, and the second sub-layers SB21_I and SB22_I may be more nitrogen (N)-rich than the first sub-layers SB11_I and SB12_I.

FIGS. 7G to 7I illustrate that two inorganic layers S1_I and S2_I are deposited, but embodiments of the present disclosure are not limited thereto. For example, a method for manufacturing a display panel according to one or more embodiments may include depositing three or more inorganic layers. For example, FIG. 6 illustrates the display panel DP (*see, e.g*. FIG. 5) including the first to fifth inorganic patterns S1, S2, S3, S4, and S5 formed by depositing and then etching five inorganic layers.

Thereafter, referring to FIG. 7J, the method for manufacturing the display panel according to one or more embodiments of the present disclosure may include depositing a second lower inorganic encapsulation layer LIL2_I on the first lower inorganic encapsulation layer LIL1_I. The first inorganic layer S1_I and the second inorganic layer S2_I which are illustrated in FIG. 7I may form the first lower inorganic encapsulation layer LIL_I.

The second lower inorganic encapsulation layer LIL2_I may be formed through a deposition process. In one or more embodiments, the second lower inorganic encapsulation layer LIL2_I may be formed through a chemical vapor deposition (a CVD process). The second lower inorganic encapsulation layer LIL2_I may be formed to cover the first lower inorganic encapsulation layer LIL1_I.

Thereafter, referring to FIG. 7K, the method for manufacturing the display panel according to one or more embodiments may include forming a second photoresist layer PR2 and forming first and second lower inorganic encapsulation patterns LIL1 and LIL2.

In the step (e.g., act or task) of forming the second photoresist layer PR2, the second photoresist layer PR2 may be formed by forming a preliminary photoresist layer, and then patterning the preliminary photoresist layer, using a mask. The second photoresist layer PR2 may be formed to have a pattern corresponding to the light-emitting opening OP-E through the patterning process.

In the step (*e.g*., act or task) of forming the first and second lower inorganic encapsulation patterns LIL1 and LIL2, the first and second lower inorganic encapsulation patterns LIL1 and LIL2 (corresponding to the first and second lower inorganic encapsulation layers LIL1_I and LIL2_I, respectively) may be patterned through dry etching so as to remove a portion except for the portion overlapping the anode AE. The first and second lower inorganic encapsulation patterns LIL1 and LIL2 overlapping the corresponding light-emitting opening OP-E may be formed from the patterned first and second lower inorganic encapsulation layers LIL1_I and LIL2_I.

The method for manufacturing the display panel according to one or more embodiments may further include patterning the dummy layer DMP-I (*see, e.g.,* FIG. 7J) so as to form dummy patterns DMP. In the step (*e.g*., act or task) of patterning the dummy layer DMP-I, the first and second dummy layers D1-I and D2-I (*see, e.g.,* FIG. 7J) may be patterned through dry etching so as to remove a portion except for the portion overlapping the anode AE.

The first and second dummy patterns D1 and D2 overlapping the corresponding light-emitting opening OP-E are formed from patterned first and second dummy layers D1-I and D2-I, and then the dummy patterns DMP including the first and second dummy patterns D1 and D2 may be formed. The first and second dummy patterns D1 and D2 may have a closed-line shape around (*e.g*., surrounding) the corresponding light-emitting regions PXA-R, PXA-G, and PXA-B (*see, e.g*., FIG. 4) on a plane (*e.g.*, in a plan view).

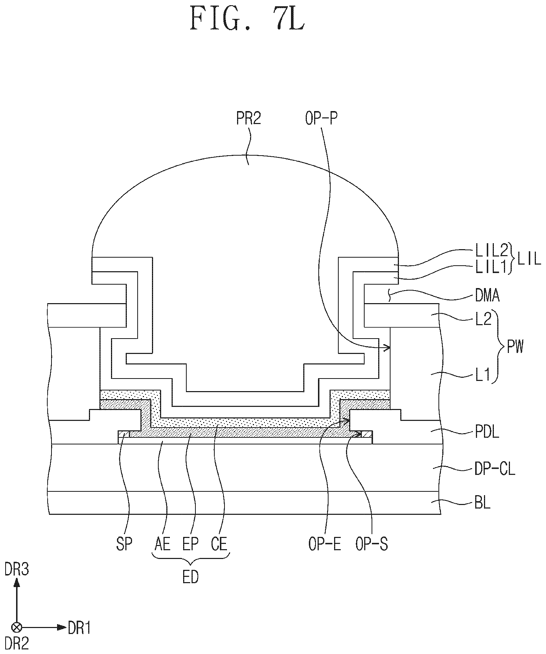

Thereafter, referring to FIG. 7L, the method for manufacturing the display panel according to one or more embodiments of the present disclosure may include removing the dummy patterns DMP (*see, e.g.,* FIG. 7K). In the step (*e.g*., act or task) of removing the dummy patterns DMP, the dummy patterns DMP formed on the partition wall PW may be removed through wet etching. The region, in which the dummy patterns DMP are removed, may be defined as a dummy region DMA (see, e.g., FIG. 7L). For example, the dummy region DMA may be formed, in a cross-sectional view, between the partition wall PW and the lower inorganic encapsulation pattern LIL.

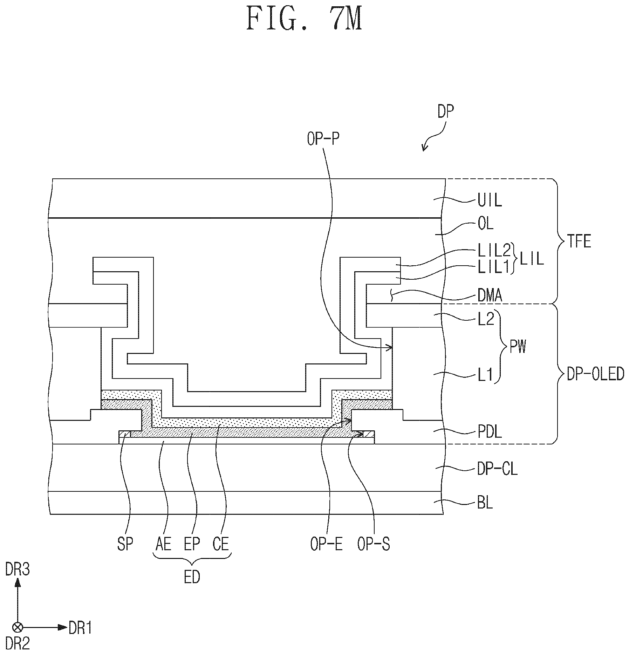

In one or more embodiments, the step (*e.g*., act or task) of removing the dummy patterns DMP may not be provided. In such embodiments, in a state in which the dummy patterns DMP remain, the organic encapsulation film OL and the upper inorganic encapsulation film UIL illustrated, for example, in FIG. 7M may be formed.

Thereafter, referring to FIG. 7M, the method for manufacturing the display panel according to one or more embodiments may include obtaining the final display panel DP by removing the second photoresist layer PR2 (*see, e.g*.*,* FIG. 7L) and then forming the organic encapsulation film OL and the upper inorganic encapsulation film UIL. The organic encapsulation film OL may be formed by applying an organic material through an inkjet method, but embodiments of the present disclosure are not limited thereto. The organic encapsulation film OL provides a planarized upper surface. Thereafter, the upper inorganic encapsulation film UIL may be formed by depositing an inorganic material. In this manner, the display panel DP including the base layer BL, the circuit element layer DP-CL, the display element layer DP-OLED, and the thin-film encapsulation layer TFE may be formed.

Between the step (*e.g*., act or task) of forming the lower inorganic encapsulation pattern LIL and the step (*e.g*., act or task) of obtaining the final display panel DP, the method may further include forming the partition wall opening and the light-emitting opening corresponding to a light-emitting region having another color in the partition wall PW and the pixel-defining film PDL, forming light-emitting elements providing other colors, and forming a lower inorganic encapsulation pattern covering the light-emitting elements providing other colors. Thus, the display panel DP including first to third light-emitting elements corresponding to the plurality of light-emitting regions PXA-R, PXA-G, and PXA-B illustrated, for example, in FIG. 4 and lower inorganic encapsulation patterns corresponding to the first to third light-emitting elements may be formed.

According to the description above, a lower inorganic encapsulation pattern may include a plurality of inorganic patterns, and the plurality of inorganic patterns may include silicon nitride (SiNₓ) and/or silicon oxynitride (SiON). The plurality of inorganic patterns including silicon nitride (SiNₓ) and/or silicon oxynitride (SiON) may cover a partition wall, thereby reducing or eliminating the phenomenon in which the lower inorganic encapsulation pattern is oxidized due to foreign substances introduced from a side surface of a first partition wall layer, a lower surface of a second partition wall layer, and/or a side surface of the second partition wall layer. Therefore, pixel defects (dark spots, pixel shrinkage, and/or the like) of a display panel caused by foreign substances may be reduced or eliminated.

As used herein, the term "substantially," "about," and similar terms are used as terms of approximation and not as terms of degree, and are intended to account for the inherent deviations in measured or calculated values that would be recognized by those of ordinary skill in the art. "Substantially" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "substantially" may mean within one or more standard deviations, or within ± 30%, 20%, 10%, 5% of the stated value.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

Further, the use of "may" when describing embodiments of the present disclosure refers to "one or more embodiments of the present disclosure."

As discussed, embodiments can provide a display panel comprising: a base layer; a pixel-defining film on the base layer and having a light-emitting opening; a partition wall on the pixel-defining film and having a partition wall opening overlapping the light-emitting opening; a light-emitting element comprising an anode, an intermediate layer, and a cathode in contact with the partition wall and in the partition wall opening; and an inorganic encapsulation pattern comprising a first inorganic encapsulation pattern and a second inorganic encapsulation pattern sequentially arranged on the cathode, wherein the first inorganic encapsulation pattern comprises a plurality of inorganic patterns repeatedly stacked.

The intermediate layer may be a light-emitting layer.

The first inorganic encapsulation pattern may cover a portion of the partition wall.

The first inorganic encapsulation pattern may cover side inner side surfaces of the partition wall opening. The first inorganic encapsulation pattern may also cover top surfaces of the partition wall, for example adjacent the partition wall opening.

The partition wall may comprise a first partition wall layer on the pixel-defining film, and a second partition wall layer on the first partition wall layer. In the partition wall opening, a first distance between two adjacent first partition wall layers that defines a first portion of the partition wall opening may be larger than a second distance between two adjacent second partition wall layers that defines a second portion of the partition wall opening.

An organic encapsulation film may cover the inorganic encapsulation pattern and provide a flat upper surface.

As discussed, embodiments can provide a method for manufacturing a display panel, the method comprising: providing a preliminary display panel comprising a base layer, a pixel-defining film on the base layer, a first preliminary partition wall layer on the pixel-defining film, and a second preliminary partition wall layer on the first preliminary partition wall layer; forming a first partition wall layer and a second partition wall layer having a partition wall opening by etching the first preliminary partition wall layer and the second preliminary partition wall layer; forming a light-emitting pattern and a cathode inside the partition wall opening; and forming an inorganic encapsulation pattern on the cathode, wherein the forming of the inorganic encapsulation pattern comprises: depositing a first inorganic encapsulation layer on the cathode, depositing a second inorganic encapsulation layer on the first inorganic encapsulation layer, and forming a first inorganic encapsulation pattern and a second inorganic encapsulation pattern by etching the first inorganic encapsulation layer and the second inorganic encapsulation layer.

The light emitting device, electronic apparatus or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. It is to be understood that the foregoing is an illustration of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display panel comprising:
a base layer;
a pixel-defining film on the base layer and having a light-emitting opening;
a partition wall on the pixel-defining film and having a partition wall opening overlapping the light-emitting opening;
a light-emitting element comprising an anode, an intermediate layer, and a cathode in contact with the partition wall and in the partition wall opening; and
an inorganic encapsulation pattern comprising a first inorganic encapsulation pattern and a second inorganic encapsulation pattern sequentially arranged on the cathode,
wherein the first inorganic encapsulation pattern comprises a plurality of inorganic patterns repeatedly stacked.

2. The display panel of claim 1, wherein the plurality of inorganic patterns each comprise silicon nitride, SiNₓ, and/or silicon oxynitride, SiON.

3. The display panel of claim 1 or 2, wherein the plurality of inorganic patterns each comprise a first sub-pattern and a second sub-pattern, and
the first sub-pattern and the second sub-pattern are sequentially and repeatedly stacked.

4. The display panel of claim 3, wherein the second sub-pattern is more nitrogen (N)-rich than the first sub-pattern.

5. The display panel of claim 3 or 4, wherein the first sub-pattern is more silicon (Si)-rich than the second sub-pattern.

6. The display panel of any one of claims 3 to 5, wherein a thickness of the first sub-pattern is smaller than a thickness of the second sub-pattern.

7. The display panel of any one of claims 1 to 6, wherein the plurality of inorganic patterns comprise five or more inorganic patterns.

8. The display panel of any one of claims 1 to 7, wherein the partition wall comprises a first partition wall layer on the pixel-defining film, and a second partition wall layer on the first partition wall layer, and
the first partition wall layer has an undercut shape with respect to the second partition wall layer.

9. A method for manufacturing a display panel, the method comprising:
providing a preliminary display panel comprising a base layer, a pixel-defining film on the base layer, a first preliminary partition wall layer on the pixel-defining film, and a second preliminary partition wall layer on the first preliminary partition wall layer;
forming a first partition wall layer and a second partition wall layer having a partition wall opening by etching the first preliminary partition wall layer and the second preliminary partition wall layer;
forming a light-emitting pattern and a cathode inside the partition wall opening; and
forming an inorganic encapsulation pattern on the cathode,
wherein the forming of the inorganic encapsulation pattern comprises:
depositing a first inorganic encapsulation layer on the cathode,
depositing a second inorganic encapsulation layer on the first inorganic encapsulation layer, and
forming a first inorganic encapsulation pattern and a second inorganic encapsulation pattern by etching the first inorganic encapsulation layer and the second inorganic encapsulation layer.

10. The method of claim 9, wherein the depositing of the first inorganic encapsulation layer on the cathode comprises:
depositing a (1-1)-th sub-layer on the cathode; and
depositing a (2-1)-th sub-layer on the (1-1)-th sub-layer;
wherein a first inorganic layer comprises the (1-1)-th sub-layer and the (2-1)-th sub-layer, and
the (1-1)-th sub-layer is silicon (Si)-rich and the (2-1)-th sub-layer is nitrogen (N)-rich.

11. The method of claim 10, wherein the depositing of the first inorganic encapsulation layer on the cathode further comprises:
depositing a (1-2)-th sub-layer on the first inorganic layer; and
depositing a (2-2)-th sub-layer on the (1-2)-th sub-layer;
wherein a second inorganic layer comprises the (1-2)-th sub-layer and the (2-2)-th sub-layer, and
the (1-2)-th sub-layer is silicon (Si)-rich and the (2-2)-th sub-layer is nitrogen (N)-rich.

12. The method of claim 10 or 11, wherein the depositing of the (1-1)-th sub-layer on the cathode comprises:
introducing a silicon-containing gas and an argon gas; and
introducing a nitrogen-containing gas and the argon gas.

13. The method of any one of claims 10 to 12, wherein the depositing of the (2-1)-th sub-layer on the (1-1)-th sub-layer comprises:
introducing a silicon-containing gas, a nitrogen-containing gas, and an argon gas; and
introducing the nitrogen-containing gas and the argon gas.
